# EUROPEAN PATENT APPLICATION

(11) **EP 4 782 518 A1**
(43) Date of publication of application: **29.07.2026**
(21) Application number: 26153819.3
(22) Date of filing: 23.01.2026
(51) Int. Cl.: C09K 11/02, C09D 11/36, C09K 11/56, C09K 11/70, C09K 11/88, H10K 50/115

(54) **INK COMPOSITION**

(30) Priority: 27.01.2025 JP 2025011325; 21.08.2025 KR 20250116735
(71) Applicant: Samsung Electronics Co., Ltd., Suwon-si, Gyeonggi-do 16677 (KR); Samsung Display Co., Ltd., Yongin-si, Gyeonggi-do 17113 (KR)
(72) Inventor: YAMADA, Yukika, Yokohama-shi (JP); KATO, Fumiaki, Yokohama-shi (JP); FUJIYAMA, Takahiro, Yokohama-shi (JP); SUGANUMA, Naotoshi, Yokohama-shi (JP); KONISHI, Yusaku, Yokohama-shi (JP); FURUTA, Keigo, Yokohama-shi (JP); MIN, Ji Hyun, Suwon-si (KR); CHANG, Hogeun, Suwon-si (KR); ENDO, Hiroko, Yokohama-shi (JP)
(74) Representative: Elkington and Fife LLP

(57) **Abstract**

An ink composition including a plurality of quantum dots, a reactive organic compound, and a solvent is provided, in which the plurality of quantum dots do not contain cadmium (Cd) or lead (Pb), and the reactive organic compound is represented by the following Chemical Formula 1: 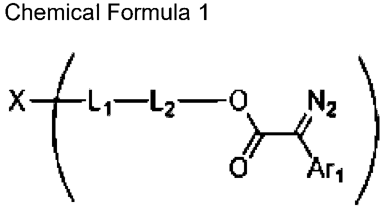 where in Chemical Formula 1, Ar₁, L₁, L₂, and X are the same as defined herein.

## Description

### FIELD OF THE INVENTION

An ink composition is disclosed.

### BACKGROUND OF THE INVENTION

Recently, quantum dots have been attracting attention as a vivid red, green, and blue (RGB) light source covering a wide color range, and electroluminescent devices using quantum dots in the light-emitting layer (hereinafter, referred to as quantum dot electroluminescent device or QD EL device). QD EL devices are being actively researched and developed as a thin-film, lightweight, low-power display and lighting device.

When realizing a QD EL device, a quantum dot light-emitting layer is positioned between the anode and cathode as a thin film with a thickness ranging from several nanometers to several hundred nanometers. Furthermore, achieving precise interface formation with surrounding layers such as the hole transport layer and electron transport layer is important. Typically, the quantum dot light-emitting layer is formed by a coating method such as spin coating or inkjet. Development of an ink composition containing quantum dots for use in the manufacture of such quantum dot electroluminescent devices is underway (see Patent References 1 to 8 listed below).
(Patent Reference 1) CN 109306207 A
(Patent Reference 2) WO 2019/225782 A
(Patent Reference 3) JP 2019-81868 A
(Patent Reference 4) JP 2020-41079 A
(Patent Reference 5) US 2018/0230321 A
(Patent Reference 6) JP 2017-043526 A
(Patent Reference 7) CN 107400414
(Patent Reference 8) CN 105907180

### SUMMARY OF THE INVENTION

In the lamination process using the coating method, when forming the upper layer of the quantum dot light-emitting layer, it is desirable to suppress the dissolution of the quantum dot light-emitting layer by the solvent. If the quantum dot light-emitting layer dissolution occurs, the interface between the upper layer and the quantum dot light-emitting layer becomes disrupted, which is one of the causes of reduced luminous efficiency and device lifespan.

In the deposition process using a coating method, attempts have been made to cross-link quantum dots to suppress dissolution of the quantum dot light-emitting layer in the solvent (enhancing process stability). However, this has not yet achieved a fundamental solution, as it can degrade the performance (e.g., luminescence characteristics and device lifespan) of quantum dot electroluminescent devices.

Therefore, one embodiment of the present invention is to provide a technology that can achieve both process stability during the manufacturing of a quantum dot electroluminescent device and performance (e.g., luminescence characteristics and device lifespan) of the quantum dot electroluminescent device.

According to an embodiment, an ink composition including a plurality of quantum dots, a reactive organic compound, and a solvent is provided, in which the plurality of quantum dots do not include cadmium (Cd) or lead (Pb), and the reactive organic compound is represented by Chemical Formula 1: 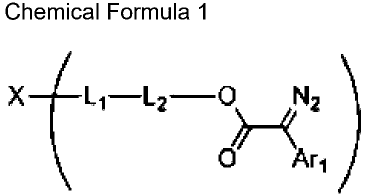 in Chemical Formula 1,
Ar₁ is a substituted or unsubstituted aromatic hydrocarbon group having 6 to 60 carbon atoms,
L₁ is a single bond or an oxygen atom,
L₂ is a single bond, a substituted or unsubstituted saturated hydrocarbon group having 1 to 60 carbon atoms, or a substituted or unsubstituted aromatic hydrocarbon group having 6 to 60 carbon atoms, and
X is a group selected from the groups represented by the following formulae (1-1) to (1-37):

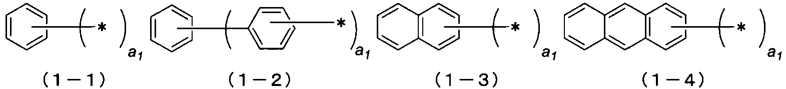

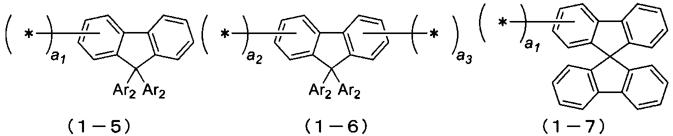

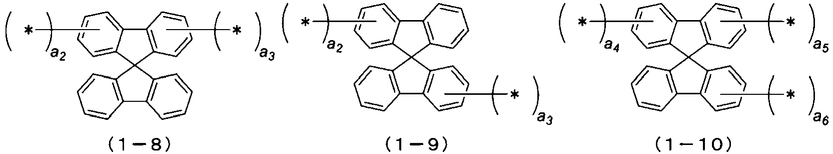

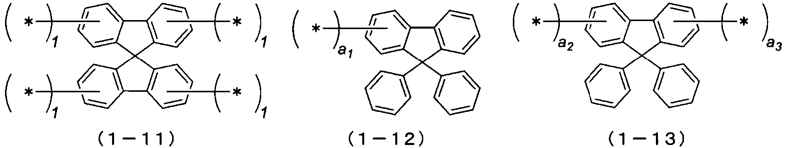

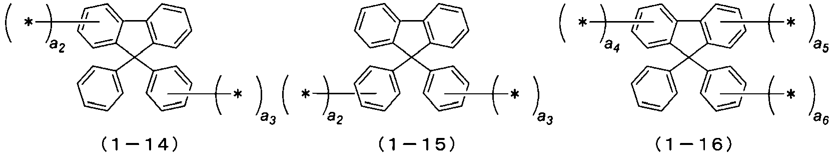

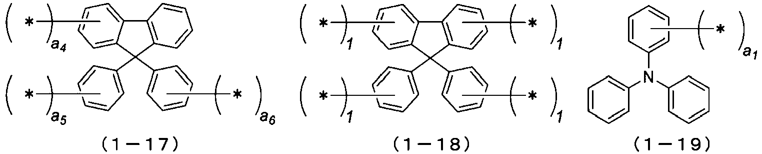

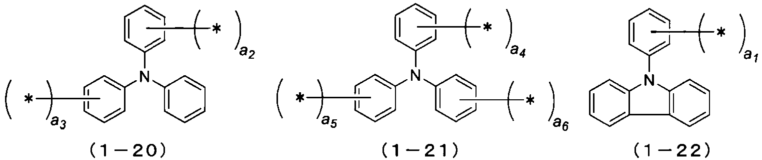

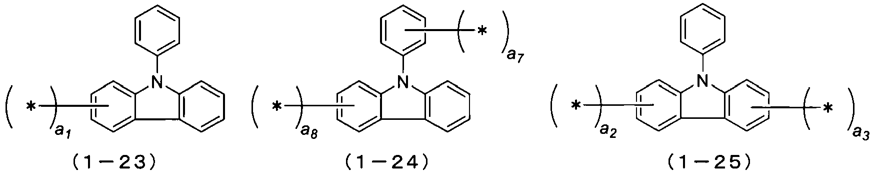

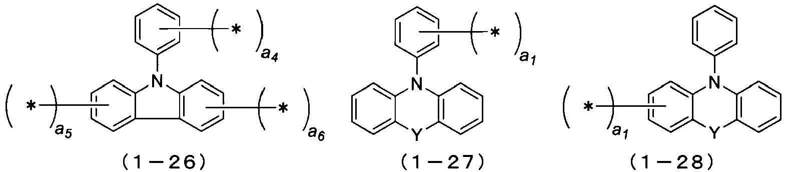

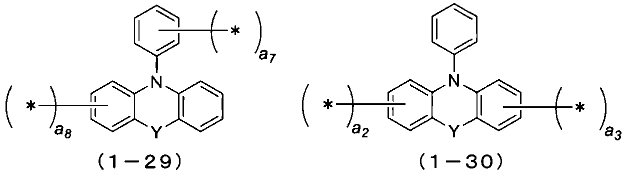

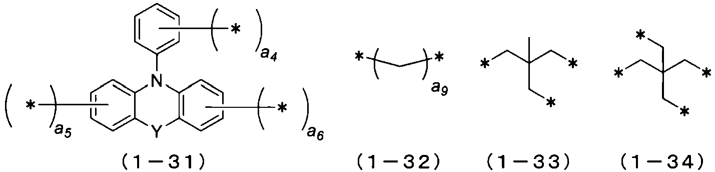

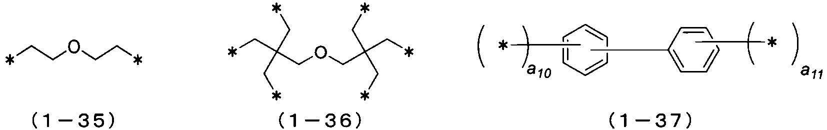

In formulae (1-1) to (1-37), * represents a binding site,
in formulae (1-1) to (1-5), (1-7), (1-12), (1-19), (1-22), (1-23), (1-27), and (1-28), a1 independently represents an integer of greater than or equal to 2 and less than or equal to 4,
in formulae (1-6), (1-8), (1-9), (1-13) to (1-15), (1-20), (1-25), and (1-30), a2 independently represents an integer of greater than or equal to 1 and less than or equal to 3, a3 independently represents 1 or 2, and the sum of a2 and a3 is independently 2, 3, or 4,
in formulae (1-10), (1-16), (1-17), (1-21), (1-26), and (1-31), a4 independently represents 1 or 2, a5 independently represents 1, a6 independently represents 1 or 2, and the sum of a4, a5, and a6 independently represents 3 or 4,
in formulae (1-24) and (1-29), a7 independently represents an integer of greater than or equal to 1 and less than or equal to 3, a8 independently represents an integer of greater than or equal to 1 and less than or equal to 3, and the sum of a7 and a8 independently represents 2, 3, or 4,
in formula (1-32), a9 is an integer of greater than or equal to 2 and less than or equal to 18,
in formula (1-37), a10 represents 1 or 2, and a11 represents 1 or 2,
in formulae (1-5) and (1-6), Ar₂ is independently a substituted or unsubstituted aromatic hydrocarbon group having 6 to 60 carbon atoms, and
in formulae (1-27) to (1-31), Y is independently -O-, -S-, -C(CH₃)₂-, or a diphenylmethylene group.

The solvent may include a compound represented by any one of formulae (2) to (5): 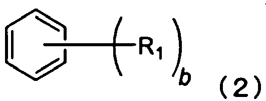 In formula (2),
R₁ may be a linear or branched saturated hydrocarbon group having 1 to 18 carbon atoms, or a cyclic saturated hydrocarbon group having 3 to 12 carbon atoms, and
b may represent an integer of greater than or equal to 1 and less than or equal to 3; 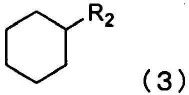
In the above formula (3),
R₂ may be a linear or branched saturated hydrocarbon group having 1 to 18 carbon atoms, or a cyclic saturated hydrocarbon group having 3 to 12 carbon atoms; 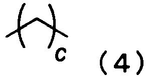
In the above formula (4),
c may represent an integer of greater than or equal to 6 and less than or equal to 18; and 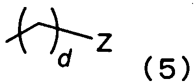
In the above formula (5),
Z may represent -OH, -COOH, -NH₂-, or -SH, and
d may represent an integer of greater than or equal to 7 and less than or equal to 17.

An average particle diameter of the plurality of quantum dots may be about 1 nanometer (nm) to about 15 nm, and an amount of the plurality of quantum dots may be from about 0.1 weight percent (wt%) to about 10.0 wt% based on a total weight of the ink composition.

An amount of the reactive organic compound may be from about 0.1 parts by weight to about 10.0 parts by weight with respect to 100 parts by weight of the plurality of quantum dots in the ink composition.

According to the embodiments, it is possible to achieve both process stability during the manufacture of a quantum dot electroluminescent device and performance of the quantum dot electroluminescent device, such as luminescence characteristics and device lifespan.

### BRIEF DESCRIPTION OF THE DRAWING

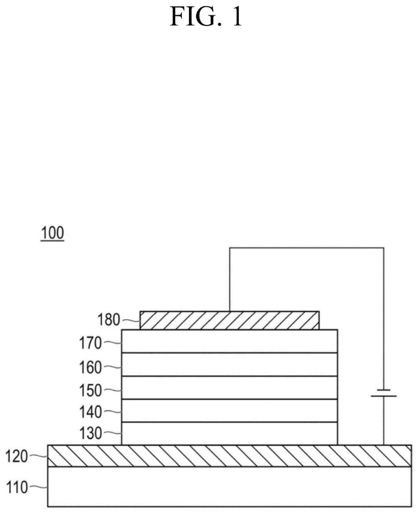

FIG. 1 is a schematic cross-sectional representation showing a quantum dot electroluminescent device according to an embodiment.

### DETAILED DESCRIPTION OF THE EMBODIMENTS

The invention now will be described more fully hereinafter with reference to the accompanying drawings, in which various embodiments are shown. This invention may, however, be embodied in many different forms, and should not be construed as limited to the embodiments set forth herein. Like reference numerals refer to like elements throughout.

Hereinafter, embodiments of the present disclosure will be described. On the other hand, the present disclosure is not limited only to the following embodiments.

It will be understood that when an element is referred to as being "on" another element, it can be directly on the other element or intervening elements may be present therebetween. In contrast, when an element is referred to as being "directly on" another element, there are no intervening elements present.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

The terminology used herein is for the purpose of describing particular embodiments only and is not intended to be limiting. As used herein, the singular forms "a," "an," and "the" are intended to include the plural forms, including "at least one," unless the content clearly indicates otherwise. Therefore, reference to "an" element in a claim followed by reference to "the" element is inclusive of one element as well as a plurality of the elements.

"At least one" is not to be construed as limiting "a" or "an." "Or" means "and/or." As used herein, the term "and/or" includes any and all combinations of one or more of the associated listed items.

It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ±10%, ±5%, or ±3% of the stated value.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

In addition, unless otherwise specified, operation and measurement of physical properties are performed under conditions of room temperature (greater than or equal to about 20 °C and less than or equal to about 25 °C)/relative humidity of greater than or equal to about 40% RH and less than or equal to about 50% RH.

### Ink Composition

According to an embodiment, an ink composition including a plurality of quantum dots, a reactive organic compound, and a solvent is provided, in which the plurality of quantum dots do not include cadmium (Cd) or lead (Pb), and the reactive organic compound is represented by Chemical Formula 1: 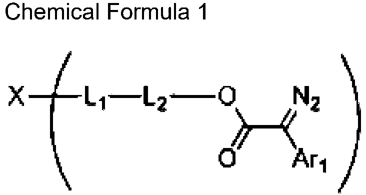 in Chemical Formula 1,
Ar₁ is a substituted or unsubstituted aromatic hydrocarbon group having 6 to 60 carbon atoms,
L₁ is a single bond or an oxygen atom,
L₂ is a single bond, a substituted or unsubstituted saturated hydrocarbon group having 1 to 60 carbon atoms, or a substituted or unsubstituted aromatic hydrocarbon group having 6 to 60 carbon atoms, and
X is a group represented by formulae (1-1) to (1-37): 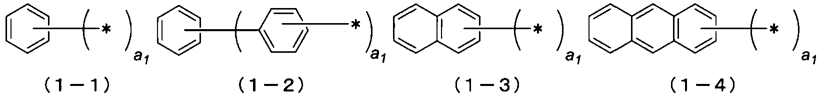 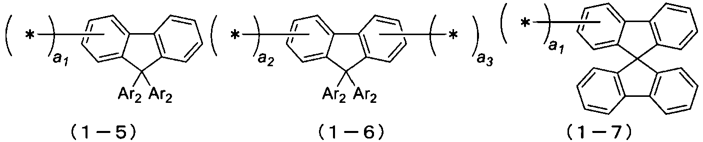 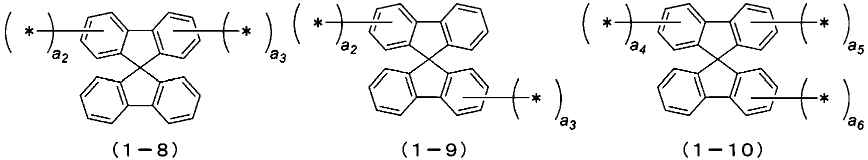 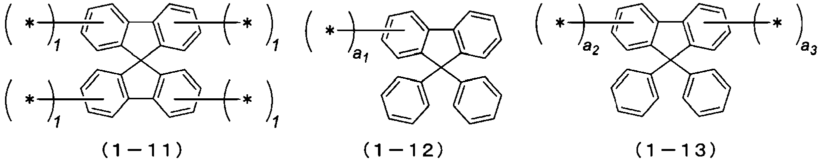 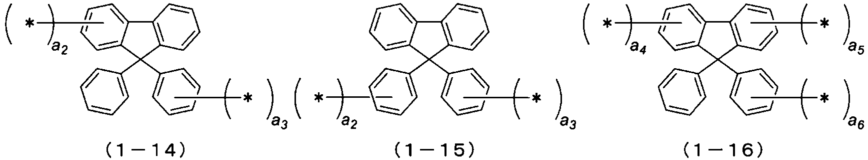 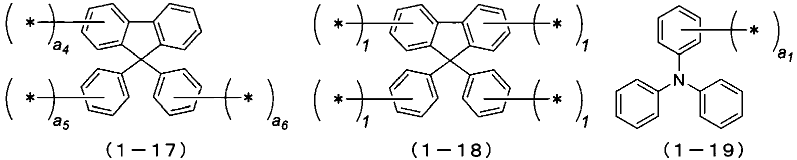 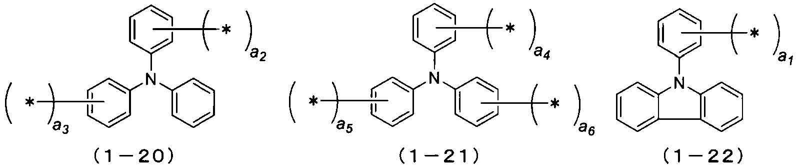 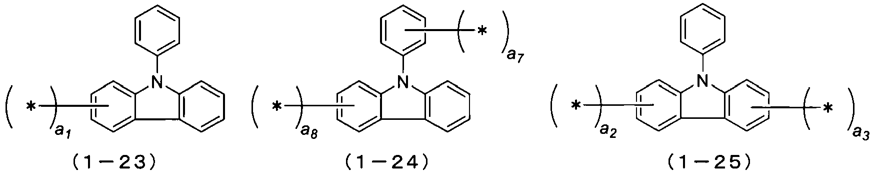 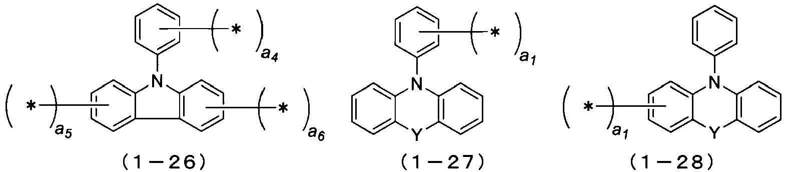 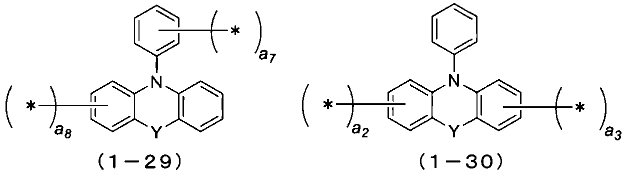 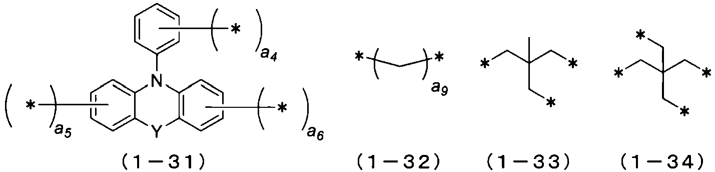 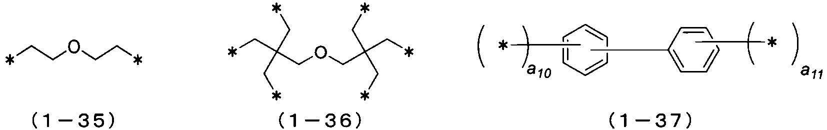
In formulae (1-1) to (1-37), * represents a binding site,
in formulae (1-1) to (1-5), (1-7), (1-12), (1-19), (1-22), (1-23), (1-27), and (1-28), a1 independently represents an integer of greater than or equal to 2 and less than or equal to 4,
in formulae (1-6), (1-8), (1-9), (1-13) to (1-15), (1-20), (1-25), and (1-30), a2 independently represents an integer of greater than or equal to 1 and less than or equal to 3, a3 independently represents 1 or 2, and the sum of a2 and a3 is independently 2, 3, or 4,
in formulae (1-10), (1-16), (1-17), (1-21), (1-26), and (1-31), a4 independently represents 1 or 2, a5 independently represents 1, a6 independently represents 1 or 2, and the sum of a4, a5, and a6 independently represents 3 or 4,
in formulae (1-24) and (1-29), a7 independently represents an integer of greater than or equal to 1 and less than or equal to 3, a8 independently represents an integer of greater than or equal to 1 and less than or equal to 3, and the sum of a7 and a8 independently represents 2, 3, or 4,
in formula (1-32), a9 is an integer of greater than or equal to 2 and less than or equal to 18,
in formula (1-37), a10 represents 1 or 2, and a11 represents 1 or 2,
in formulae (1-5) and (1-6), Ar₂ is independently a substituted or unsubstituted aromatic hydrocarbon group having 6 to 60 carbon atoms, and
in formulae (1-27) to (1-31), Y is independently -O-, -S-, -C(CH₃)₂-, or a diphenylmethylene group.

The solvent may include a compound represented by any one of the following formulae (2) to (5): 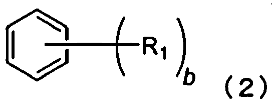 In the above formula (2),
R₁ may be a linear or branched saturated hydrocarbon group having 1 to 18 carbon atoms, or a cyclic saturated hydrocarbon group having 3 to 12 carbon atoms, and
b may represent an integer of greater than or equal to 1 to and less than or equal 3; 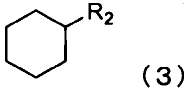
In formula (3),
R₂ may be a linear or branched saturated hydrocarbon group having 1 to 18 carbon atoms, or a cyclic saturated hydrocarbon group having 3 to 12 carbon atoms; 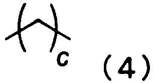
In formula (4),
c may represent an integer of greater than or equal to 6 and less than or equal to 18; and 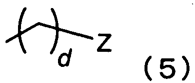
In formula (5),
Z may represent -OH, -COOH, -NH₂-, or -SH, and
d may represent an integer of greater than or equal to 7 and less than or equal to 17.

An average particle diameter of the plurality of quantum dots may be about 1 nm to about 15 nm, and an amount of the plurality of quantum dots may be from about 0.1 wt% to about 10.0 wt% based on a total weight of the ink composition.

An amount of the reactive organic compound may be greater than or equal to about 0.1 parts by weight and less than or equal to about 10.0 parts by weight with respect to 100 parts by weight of the plurality of quantum dots in the ink composition.

By having the above-described configuration, the ink composition according to an embodiment may achieve both process stability during the manufacture of a quantum dot electroluminescent device and performance of the quantum dot electroluminescent device, such as luminescence characteristics and device lifespan.

Although not intended to be bound by a specific theory, the mechanism by which the above problem is solved by the ink composition (e.g., quantum dot ink composition) according to one embodiment can be estimated as follows.

When manufacturing quantum dot electroluminescent devices using a wet deposition method, such as inkjet, the device is manufactured by repeating the process of applying and drying a liquid. When a liquid containing a solvent is applied to form a different layer on a dry film (quantum dot layer) containing quantum dots, the solvent may penetrate the quantum dot layer, causing the quantum dot layer to dissolve and intermixing with the upper layer. Intermixing may deteriorate the device characteristics. Therefore, it is thought that intermixing may be suppressed by strengthening the quantum dot layer. The inventors of the present application thought that the quantum dot layer could be strengthened, and intermixing could be suppressed by using a compound capable of crosslinking quantum dots. However, when a compound having an azide group (-N₃) (e.g., J. Yang, et al, Nat. Commun., 11(2020) 2874.) was used to crosslink quantum dots, the structure after crosslinking contained an amine, resulting in residual active protons. The inventors of the present application discovered that the residual presence of active protons deteriorates the device characteristics. On the other hand, when a reactive organic compound having a diazo group (=N₂) is used, the structure after crosslinking does not contain amines, and no active protons remain. Accordingly, since deterioration of the quantum dot electroluminescent device due to the presence of active protons may be suppressed, it is thought that the ink composition according to an embodiment may achieve both process stability during the manufacture of the quantum dot electroluminescent device and performance of the quantum dot electroluminescent device, such as luminescence characteristics and device lifespan.

The above mechanism is speculative, and one implementation is not at all bound by the above mechanism.

The following describes in detail the features of the ink composition according to an embodiment.

### Quantum Dot

An ink composition according to an embodiment includes a plurality of quantum dots. Quantum dots (semiconductor nanoparticles) are semiconductor nanoparticles of a predetermined size that exhibit quantum confinement effects.

Quantum dots (semiconductor nanoparticles) may be synthesized using wet chemical processes, organometallic chemical vapor deposition, molecular beam epitaxy, or other similar processes. Among these, wet chemical processes involve adding precursor materials to an organic solvent to grow particles.

In wet chemical processes, organic solvents naturally coordinate with the surface of quantum dot crystals as they grow, acting as dispersants to control crystal growth. Therefore, wet chemical processes offer a simpler and more cost-effective way to control the growth of semiconductor nanoparticles compared to vapor-phase deposition methods such as metal-organic chemical vapor deposition (MOCVD) or molecular beam epitaxy (MBE).

Quantum dots (semiconductor nanoparticles) may control the energy band gap by controlling their size, so that light of various wavelengths may be obtained from the light-emitting layer (quantum dot light-emitting layer). Therefore, by using multiple quantum dots of different sizes, a display that emits light of multiple wavelengths is possible. The size of the quantum dots may be selected to emit red, green, and blue light, enabling a color display. Furthermore, the sizes of the quantum dots may be combined to emit white light of various colors.

Quantum dots do not contain cadmium (Cd) or lead (Pb). Examples of quantum dots (semiconductor nanoparticles) may include a semiconductor material selected from a Group II-VI semiconductor compound; a Group III-V semiconductor compound; a Group IV-VI semiconductor compound; a Group IV element or compound; and a combination thereof.

The Group II-VI semiconductor compound is not particularly limited, but may include, for example, a binary compound selected from ZnS, ZnSe, ZnTe, ZnO, HgS, HgSe, HgTe, or a mixture thereof; a ternary compound selected from ZnSeS, ZnTeSe, ZnSTe, HgSeS, HgSeTe, HgSTe, HgZnS, HgZnSe, HgZnTe, or a mixture thereof; and a quaternary compound selected from HgZnSeS, HgZnSeTe, HgZnSTe, or a mixture thereof.

The Group III-V semiconductor compound is not particularly limited, but may include, for example, a binary compound selected from GaN, GaP, GaAs, GaSb, AIN, AlP, AlAs, AlSb, InN, InP, InAs, InSb, or a mixture thereof; a ternary compound selected from GaNP, GaNAs, GaNSb, GaPAs, GaPSb, AINP, AlNAs, AlNSb, AlPAs, AlPSb, InNP, InNAs, InNSb, InPAs, InPSb, or a mixture thereof; and a quaternary compound selected from GaAlNP, GaAINAs, GaAINSb, GaAlPAs, GaAlPSb, GalnNP, GalnNAs, GaInNSb, GalnPAs, GalnPSb, InAlNP, InAlNAs, InAlNSb, InAlPAs, InAlPSb, or a mixture thereof.

The Group IV-VI semiconductor compound is not particularly limited, but may include, for example, a binary compound selected from SnS, SnSe, SnTe, or a mixture thereof; a ternary compound selected from SnSeS, SnSeTe, SnSTe, or a mixture thereof.

The Group IV element or compound is not particularly limited, but may include, for example, single-element selected from Si, Ge, or a mixture thereof; and a binary compound selected from SiC, SiGe, or a mixture thereof.

The quantum dot may consist of one type of compound or may consist of two or more types of compounds. For example, the quantum dot may have a core-shell structure including a core made of a semiconductor compound and a shell made of a semiconductor compound different from the core. The luminous efficiency of the quantum dot may be increased by using a semiconductor compound for the shell that has a bandgap higher than that of the semiconductor compound forming the core, so excitons are more confined to the core. Examples of core/shell structures (core/shell) having such a relationship of bandgap may include InP/ZnS, CulnS/ZnS, ZnTeSe/ZnSe/ZnS, InP/ZnSe/ZnS, etc.

As an example, an average particle diameter (average diameter) of the plurality of quantum dots (semiconductor nanoparticles) is not particularly limited but may be about 1 nanometer (nm) to about 15 nm. In terms of light emitting properties and dispersion stability of quantum dots, the average particle diameter may be about 7 nm to about 15 nm. The average particle diameter of the plurality of quantum dots in this specification is calculated by measuring diameters of circles with an area equal to the projected area of 100 particles of the plurality of quantum dots using a transmission electron microscope (TEM), and using the arithmetic mean of these values. An example of a method for calculating the average particle diameter of the plurality of quantum dots is provided below:
(1) A quantum dot dispersion containing no reactive organic compounds is placed on a grid for a TEM measurement sample table to prepare a measurement sample.
(2) Measurement sample is photographed using a transmission electron microscopy (TEM) (e.g., the HT7800 series manufactured by Hitachi High-Technologies) (at a magnification of 20,000x or more).
(3) The diameters of circles having an area equal to the projected area of 100 particles of the plurality of quantum dots are measured, and the arithmetic mean is calculated.

As for the quantum dots, those having an organic ligand that includes an organic coordinating group coordinated to the surface thereof may be used. By adding an organic ligand to the quantum dot raw material solution during the synthesis of quantum dots, excessive crystal growth may be minimized and quantum dots within a desired particle size range may be obtained. In addition, quantum dots having a surface layer including organic ligands on the surface may prevent aggregation during and after the synthesis preparation.

The organic ligand may be an organic compound having a coordinating group that binds to the cation included in the quantum dot. Examples of the coordinating group may include a halogen atom, a carboxy group, a carboxylic anhydride group, an amino group, an ammonium group, a mercapto group, a sulfide group, a sulfoxide group, a phosphine group, a phosphine oxide group, a phosphoric acid group, a phosphonic acid group, a phosphinic acid group, a sulfonic acid group, a boronic acid group, a heterocyclic ring group, and the like. These organic ligands may be used alone or in combination of two or more.

Examples of the halogen atom-containing compound include halogenated alkyl compounds having a linear or branched alkyl group having 1 to 30 carbon atoms. Specific examples of such halogenated alkyl compounds may include, for example, methyl chloride, methyl bromide, methyl iodide, ethyl chloride, ethyl bromide, ethyl iodide, propyl chloride, propyl bromide, propyl iodide, butyl chloride, butyl bromide, butyl iodide, hexyl chloride, bromide hexyl, octyl chloride, octyl bromide, decyl chloride, and the like.

Examples of the carboxy group-containing compound may include linear or branched aliphatic carboxylic compounds having 1 to 30 carbon atoms. Specific examples of such aliphatic carboxylic acid compounds may include, for example, arachidonic acid, crotonic acid, trans-2-decenoic acid, erucic acid, 3-decenoic acid, cis-4,7,10,13,16,19-docosahexaenoic acid, 4-decenoic acid, allcis-5,8,11,14,17-eicosapentaenoic acid, allcis-8,11,14-eicosatrienoic acid, cis-9-hexadecenoic acid, trans-3-hexenoic acid, trans-2-hexenoic acid, 2-heptenoic acid, 3-heptenoic acid, 2-hexadecenoic acid, linolenic acid, linoleic acid, γ-linolenic acid, 3-nonenoic acid, 2-nonenoic acid, trans-2-octenoic acid, petroseric acid, elaidic acid, oleic acid, 3-octenoic acid, trans-2-pentenoic acid, trans-3-pentenoic acid, ricinolic acid, sorbic acid, 2-tridecenoic acid, cis-15-tetrachosenoic acid, 10-undecenoic acid, 2-undecenoic acid, acetic acid, butyric acid, behenic acid, cerotinic acid, decanoic acid, arachidic acid, heneicosanoic acid, heptadecanoic acid, heptanoic acid, hexanoic acid, heptacosanoic acid, lauric acid, myristic acid, malic acid, octadecanoic acid, nonadecanoic acid, nonacosanoic acid, n-octanoic acid, palmitic acid, pentadecanoic acid, pyropionic acid, pentacosanoic acid, nonanoic acid, stearic acid, lignoceric acid, trichosanoic acid, tridecanoic acid, undecanoic acid, valeric acid, and the like.

Examples of the amino group-containing compound may include aliphatic amine compounds having a linear or branched alkyl group having 1 to 30 carbon atoms. Specific examples of such aliphatic amine compounds may include, for example, 1-amino heptadecane, 1-amino nonadecane, heptadecan-9-amine, stearyl amine, oleyl amine, 2-n-octyl-1-dodecyl amine, allyl amine, amyl amine, 2-ethoxyethyl amine, 3-ethoxypropyl amine, isobutyl amine, isoamyl amine, 3-methoxy propyl amine, 2-methoxyethyl amine, 2-methylbutyl amine, neopentyl amine, n-propyl amine, methyl amine, ethyl amine, n-butyl amine, n-pentyl amine, n-hexyl amine, n-heptyl amine, n-octyl amine, n-nonyl amine, n-decyl amine, n-undecyl amine, n-dodecyl amine, n-tridecyl amine, n-tetradecyl amine, n-pentadecyl amine, n-hexadecyl amine, n-octadecyl amine, tri(n-hexyl) amine, tri (n-octyl) amine, tri(n-decyl) amine, and the like.

Examples of the mercapto group-containing compound may include hexyl mercaptan, octyl mercaptan, and lauryl mercaptan.

Examples of the sulfide group-containing compound may include dialkyl sulfides such as dibutyl sulfide.

Examples of the sulfoxide group-containing compound may include dialkyl sulfoxides such as dimethyl sulfoxide and dibutyl sulfoxide.

Examples of the phosphine group-containing compound may include trialkyl phosphines such as tripropyl phosphine, tributyl phosphine, trihexyl phosphine, and trioctyl phosphine.

Examples of the phosphine oxide group-containing compound may include trialkyl phosphine oxides such as tripropyl phosphine oxide, tributyl phosphine oxide, trihexyl phosphine oxide, trioctyl phosphine oxide, and tridecyl phosphine oxide.

Examples of the heterocyclic ring group-containing compound may include a nitrogen-containing heterocyclic ring-containing compound such as pyridine, lutidine, collidine, and quinolines; and a sulfur-containing heterocyclic ring compound such as thiophene.

Among these organic ligands, at least one selected from a halogenated alkyl compound, a mercapto group-containing compound, and an aliphatic carboxylic acid compound may be used to achieve dispersion stability and light emitting properties of quantum dots. In an example embodiment, the surface of the quantum dot may be coordinated with at least one organic ligand selected from a halogenated alkyl compound, a mercapto group-containing compound, an aliphatic carboxylic acid compound, or a combination thereof. In addition, the organic ligand may be at least one selected from oleic acid, heptanoic acid, hexanoic acid, heptacosanoic acid, lauric acid, hexyl mercaptan, octyl mercaptan, and lauryl mercaptan.

The amount of the organic ligands coordinated to the quantum dots is not particularly limited. However, from the perspective of film thickness control of a quantum dot film following ejection of an ink composition in an inkjet printing process, the coordinated ligand may be present in an amount of less than or equal to about 30 parts by weight, for example, less than or equal to about 20 parts by weight, or less than or equal to about 15 parts by weight, with respect to 100 parts by weight of the quantum dots. The amount of the organic ligands coordinated to the quantum dots may be, for example, greater than or equal to about 1 part by weight, with respect to 100 parts by weight of the quantum dots. For example, the amount of the organic ligands coordinated to the quantum dots may be greater than or equal to about 3 parts by weight, greater than or equal to about 5 parts by weight, greater than or equal to about 10 parts by weight, or greater than or equal to about 15 parts by weight, with respect to 100 parts by weight of the quantum dots. For example, the amount of the organic ligands coordinated to the quantum dots may be greater than or equal to about 1 part by weight and less than or equal to 30 parts by weight, greater than or equal to about 1 part by weight and less than or equal to 25 parts by weight, greater than or equal to about 3 parts by weight and less than or equal to 25 parts by weight, greater than or equal to about 5 parts by weight and less than or equal to 30 parts by weight, greater than or equal to about 5 parts by weight and less than or equal to 25 parts by weight, greater than or equal to about 10 parts by weight and less than or equal to 30 parts by weight, greater than or equal to about 10 parts by weight and less than or equal to 25 parts by weight, greater than or equal to about 10 parts by weight and less than or equal to 20 parts by weight, greater than or equal to about 15 parts by weight and less than or equal to 30 parts by weight, or greater than or equal to about 15 parts by weight and less than or equal to 25 parts by weight, with respect to 100 parts by weight of the quantum dots, and is not limited thereto.

In an example embodiment, the surface of the quantum dot may be coordinated with at least one organic ligand selected from a halogenated alkyl compound, a mercapto group-containing compound, an aliphatic carboxylic acid compound, or a combination thereof, and the amount of the organic ligands coordinated to the quantum dots may be less than or equal to 30 parts by weight, with respect to 100 parts by weight of the quantum dots.

The quantum dots in which an organic ligand having a coordinating group is coordinated on the surface may be synthesized according to, for example, J. Am. Chem. Soc., 115, pp. 8706-8715 (1993), J. Phys. Chem., 101, pp. 9463-9475 (1997), Nature volume 575, pp. 634-638 (2019), and the like. Moreover, commercially available products may also be used.

An amount of the quantum dots in the ink composition according to an embodiment may be greater than or equal to about 0.1 wt% and less than or equal to about 10.0 wt%, for example, be greater than or equal to about 0.5 wt% and less than or equal to about 8.0 wt%, greater than or equal to about 1.0 wt% and less than or equal to about 6.0 wt%, greater than or equal to about 1.0 wt% and less than or equal to about 5.0 wt%, greater than or equal to about 2.0 wt% and less than or equal to about 5.0 wt%, based on a total weight (100 wt%) of the ink composition, and is not limited thereto.

### Reactive Organic Compound

The ink composition according to an embodiment includes a reactive organic compound. The reactive organic compound is represented by Chemical Formula 1. As described above, when the quantum dots are crosslinked by the reactive organic compound, no active protons remain in the structure after the crosslinking. Further, while the quantum dots are sensitive to heat, heat is required for crosslinking the quantum dots. The reactive organic compound included in the ink composition according to an embodiment may perform crosslinking at lower temperature than the compound including an azide group, whereby completing the crosslinking fast. 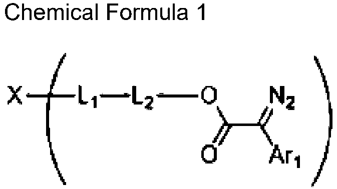 in Chemical Formula 1,
Ar₁ may be a substituted or unsubstituted aromatic hydrocarbon group having 6 to 60 carbon atoms.

The aromatic hydrocarbon group of Ar₁ may include 6 to 60 carbon atoms, i.e., the ring-forming carbon atoms.

Examples of Ar₁, which is not substituted, may include monovalent groups derived from aromatic hydrocarbons such as benzene, pentalene, indene, naphthalene, anthracene, azulene, heptalene, acenaphthene, phenalene, fluorene, phenanthrine, biphenyl, terphenyl, quarterphenyl, quinquephenyl, sexiphenyl, pyrene, 9,9-diphenylfluorene, 9,9'-spirobi[fluorene], 9,9-dialkylfluorene, indeno[1,2-b]fluorene, etc. For example, Ar₁ may be a monovalent group derived from benzene, fluorene, biphenyl, terphenyl, indeno[1,2-b]fluorene, or a combination thereof. For example, Ar₁ may be a monovalent group derived from benzene, fluorene, biphenyl, indeno[1,2-b]fluorene, or a combination thereof. In an example embodiment, Ar₁ may be a monovalent group derived from benzene.

When at least one hydrogen atom of the Ar₁ is substituted by a substituent, the number of substituent(s) is not specifically limited. For example, the number of the substituent may be greater than or equal to 1 and less than or equal to 3, greater than or equal to 1 and less than or equal to 2, or for example, may be 1. In an example embodiment, Ar₁ may be unsubstituted. In another example embodiment, Ar₁ may include one substituent. When Ar₁ includes a substituent, the position at which substitution occurs is not specifically limited.

When Ar₁ includes a substituent, the substituent may not be specifically limited. For example, the substituent may include, an alkyl group, a cycloalkyl group, a hydroxyalkyl group, an alkoxyalkyl group, an alkoxy group, a cycloalkoxy group, an alkenyl group, an alkynyl group, an amino group, an aryl group, an aryloxy group, an alkylthio group, a cycloalkylthio group, an arylthio group, an alkoxycarbonyl group, an aryloxycarbonyl group, a hydroxyl group (-OH), a carboxyl group (-COOH), a thiol group (-SH), a cyano group (-CN), a halogen group, etc. When two or more hydrogen atoms are substituted, the types of substituents may be the same as or different from each other. In addition, the substituent is not identical to the group being substituted. For example, an alkyl group is not substituted with another alkyl group.

The alkyl group may be a linear or branched, but, for example, a linear alkyl group having 1 or more and 18 or less carbon atoms or a branched alkyl group having 3 or more and 18 or less carbon atoms may be included. For example, the alkyl group may include methyl group, ethyl group, n-propyl group, isopropyl group, n-butyl group, isobutyl group, sec-butyl group, tert-butyl group, n-pentyl group, isopentyl group, tert-pentyl group, neopentyl group, 1,2-dimethylpropyl group, n-hexyl group, isohexyl group, 1,3-dimethylbutyl group, 1-isopropylpropyl group, 1,2-dimethylbutyl group, n-heptyl group, 1,4-dimethylpentyl group, 3-ethylpentyl group, 2-methyl-1-isopropylpropyl group, 1-ethyl-3-methylbutyl group, n-octyl group, 2-ethylhexyl group, 3-methyl-1-isopropylbutyl group, 2-methyl-1-isopropyl group, 1-tert-butyl-2-methylpropyl group, n-nonyl group, 3,5,5-trimethylhexyl group, n-decyl group, isodecyl group, n-undecyl group, 1-methyldecyl group, n-dodecyl group, n-tridecyl group, n-tetradecyl group, n-pentadecyl group, n-hexadecyl group, n-heptadecyl group, n-octadecyl group, etc.

The cycloalkyl group may include, for example, cyclopropyl group, cyclobutyl group, cyclopentyl group, cyclohexyl group, etc.

The hydroxyalkyl group may include the ones having 1 to 3 hydroxy groups, 1 or 2 hydroxy groups, or for example, 1 hydroxy group, as a substituent of an alkyl group, for example, hydroxymethyl group, hydroxyethyl group, etc.

The alkoxyalkyl group may include the ones having 1 to 3 alkoxy groups, 1 or 2 alkoxy groups, or for example, 1 alkoxy group, as a substituent of an alkyl group.

The alkoxy group may include, for example, methoxy group, ethoxy group, propoxy group, isopropoxy group, butoxy group, pentyloxy group, hexyloxy group, heptyloxy group, octyloxy group, nonyloxy group, decyloxy group, undecyloxy group, dodecyloxy group, tridecyloxy group, tetradecyloxy group, pentadecyloxy group, hexadecyloxy group, heptadecyloxy group, octadecyloxy group, 2-ethylhexyloxy group, 3-ethylpentyloxy group, etc.

The cycloalkoxy group may include, for example, cyclopropyloxy group, cyclobutyloxy group, cyclopentyloxy group, cyclohexyloxy group, etc.

The alkenyl group may include, for example, vinyl group, allyl group, 1-propenyl group, isopropenyl group, 1-butenyl group, 2-butenyl group, 3-butenyl group, 1-pentenyl group, 2-pentenyl group, 3-pentenyl group, 1-hexenyl group, 2-hexenyl group, 3-hexenyl group, 1-heptenyl group, 2-heptenyl group, 5-heptenyl group, 1-octenyl group, 3-octenyl group, 5-octenyl group, etc.

The alkynyl group may include, for example, acetylenyl group, 1-propynyl group, 2-propynyl group, 1-butynyl group, 2-butynyl group, 3-butynyl group, 1-pentetyl group, 2-pentetyl group, 3-pentetyl group, 1-hexynyl group, 2-hexynyl group, 3-hexynyl group, 1-heptynyl group, 2-heptynyl group, 5-heptynyl group, 1-octynyl group, 3-octynyl group, 5-octynyl group, etc.

The aryl group may include, for example, phenyl group, naphthyl group, biphenyl group, fluorenyl group, anthryl group, pyrenyl group, azulenyl group, acenaphthylenyl group, terphenyl group, phenanthryl group, etc.

The aryloxy group may include for example, phenoxy group, naphthyloxy group, etc.

The alkylthio group may include, for example, methylthio group, ethylthio group, propylthio group, pentylthio group, hexylthio group, octylthio group, dodecylthio group, etc.

The cycloalkylthio group may include, for example, cyclopentylthio group, cyclohexylthio group, etc.

The arylthiol group may include, for example, phenylthiol group, naphtylthio group, etc.

The alkoxycarbonyl group may include, for example, methyloxycarbonyl group, ethyloxycarbonyl group, butyloxycarbonyl group, octyloxycarbonyl group, dodecyloxycarbonyl group, etc.

The aryloxycarbonyl group may include, for example, phenyloxycarbonyl group, naphthyloxycarbonyl group, etc.

The halogen group may include, for example, fluoro group, chloro group, bromo group, iodo group, etc.

The substituent that may be present when any one of the hydrogen atoms of Ar₁ is substituted may be a linear or branched alkyl group having 1 to 8 carbon atoms or halogen group, for example, a linear or branched alkyl group having 1 to 3 carbon atoms or halogen group, for example, a methyl group or a fluoro group.

In Chemical Formula 1, L₁ may be a single bond or an oxygen atom. For example, L₁ may be oxygen atom.

In Chemical Formula 1, L₂ may be a single bond, a substituted or unsubstituted saturated hydrocarbon group having 1 to 60 carbon atoms, or a substituted or unsubstituted aromatic hydrocarbon group having 6 to 60 carbon atoms.

The saturated hydrocarbon group having 1 to 60 carbon atoms in L₂ is not specifically limited. Examples of the L₂, which is not substituted, may include methylene group, ethylene group, trimethylene group, propylene group, tetramethylene group, pentamethylene group, hexamethylene group, heptamethylene group, octamethylene group, etc.

The aromatic hydrocarbon group in L₂ is not specifically limited, as long as it has 6 to 60 carbon atoms (i.e., ring-forming carbon atoms). Examples of the L₂, which is not substituted, may include a divalent group derived from aromatic hydrocarbons such as benzene, pentarene, indene, naphthalene, anthracene, azulene, heptalene, acenaphthene, phenalene, fluorene, phenanthrine, biphenyl, terphenyl, quarterphenyl, quinquephenyl, sexiphenyl, pyrene, 9,9-diphenylfluorene, 9,9'-spirobi[fluorene], 9,9-dialkylfluorene, indeno[1,2-b]fluorene, etc. For example, L₂ may be a divalent group derived from benzene, fluorene, biphenyl, terphenyl, indeno[1,2-b]fluorene, or a combination thereof. For example, L₂ may be a divalent group derived from benzene, fluorene, biphenyl, indeno[1,2-b]fluorene, or a combination thereof. In an example embodiment, L₂ may be a divalent group derived from benzene.

The substituent that may be present when any one of the hydrogen atoms of L₂ is substituted may be the same as of Ar₁. For example, the substituent may be a linear or branched alkyl group having 1 to 8 carbon atoms, for example, a linear or branched alkyl group having 1 to 3 carbon atoms.

L₂ may be a single bond, or a substituted or unsubstituted saturated hydrocarbon group having 1 to 8 carbon atoms, for example, may be a single bond, or methylene group, ethylene group, a trimethylene group, a propylene group, a tetramethylene group, pentamethylene group, a hexamethylene group, a heptamethylene group, or an octamethylene group. For example, L₂ may be a single bond, or methylene group, ethylene group, a trimethylene group, or a propylene group.

In Chemical Formula 1, X may be a group selected from the groups represented by the following formulae (1-1) to (1-37):

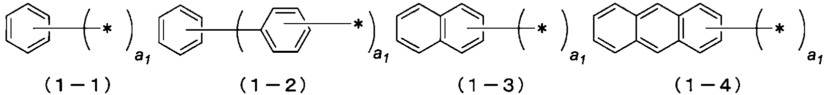

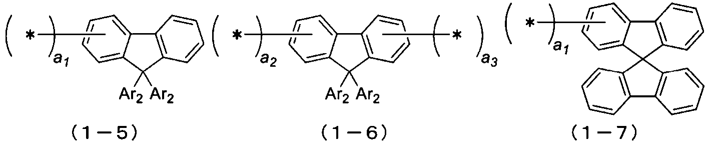

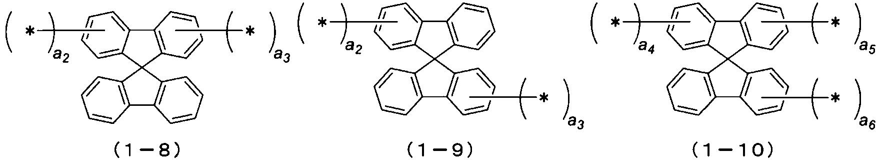

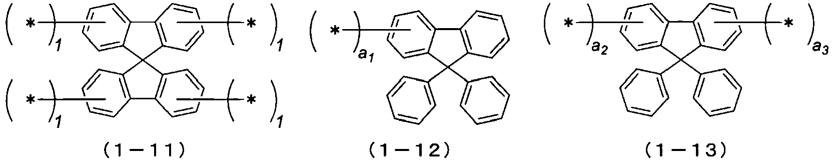

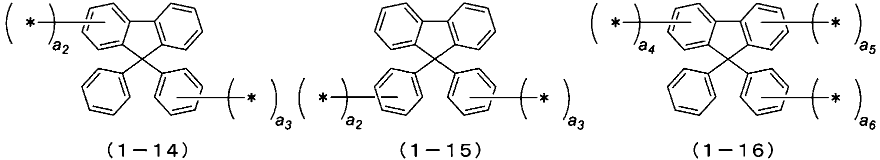

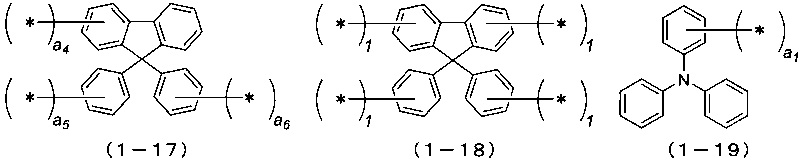

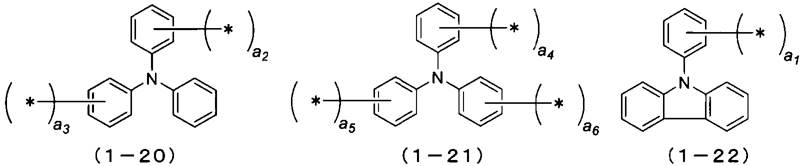

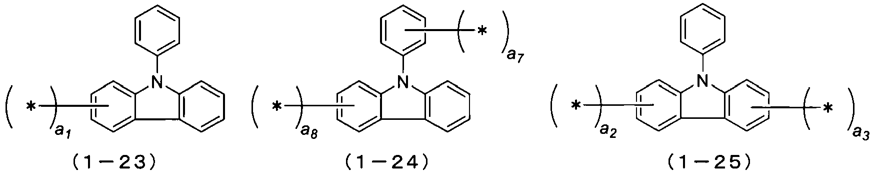

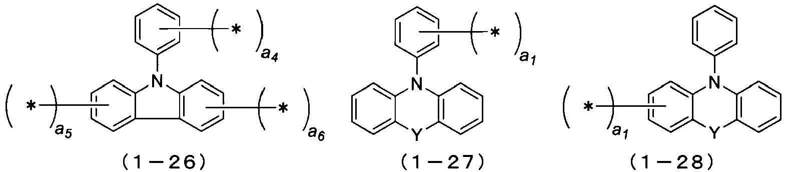

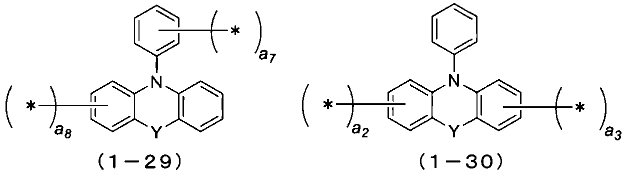

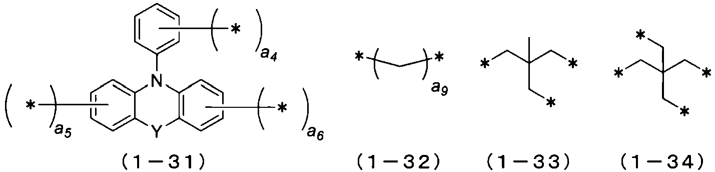

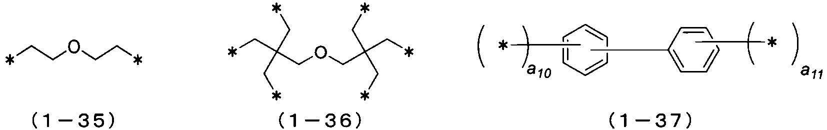

In the above formulae (1-1) to (1-37), * represents a binding site.

In the above formulae (1-1) to (1-5), (1-7), (1-12), (1-19), (1-22), (1-23), (1-27), and (1-28), a1 may independently represent an integer of greater than or equal to 2 and less than or equal to 4.

In the above formulae (1-6), (1-8), (1-9), (1-13) to (1-15), (1-20), (1-25), and (1-30), a2 may independently represent an integer of greater than or equal to 1 and less than or equal to 3, a3 may independently represent 1 or 2, and the sum of a2 and a3 may independently be 2, 3, or 4.

In the above formulae (1-10), (1-16), (1-17), (1-21), (1-26), and (1-31), a4 may independently represent 1 or 2, a5 may independently represent 1, a6 may independently represent 1 or 2, and the sum of a4, a5, and a6 may independently represent 3 or 4.

In the above formulae (1-24) and (1-29), a7 may independently represent an integer of greater than or equal to 1 and less than or equal to 3, a8 may independently represent an integer of greater than or equal to 1 and less than or equal to 3, and the sum of a7 and a8 may independently represent 2, 3, or 4.

In the above formula (1-32), a9 may be an integer of greater than or equal to 2 and less than or equal to 18.

In the above formula (1-37), a10 may represent 1 or 2, and a11 may represent 1 or 2.

In the above formulae (1-5) and (1-6), Ar₂ may be each independently a substituted or unsubstituted aromatic hydrocarbon group having 6 to 60 carbon atoms.

The substituted or unsubstituted aromatic hydrocarbon group having 6 to 60 carbon atoms of Ar₂ may be the same as those of Ar₁. The types of two Ar₂ present in one molecule may be the same as or different from each other.

In the above formulae (1-27) to (1-31), Y may each independently be -O-, -S-, - C(CH₃)₂-, or a diphenylmethylene group.

In Chemical Formula 1, X may be a group selected from the groups represented by the following formulae (1-38) to (1-105):

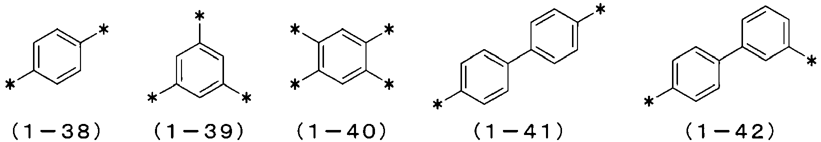

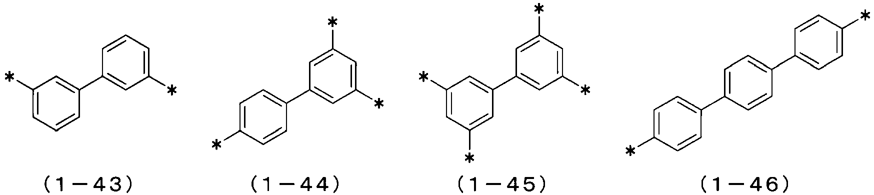

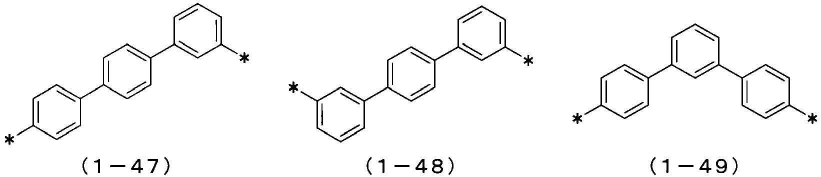

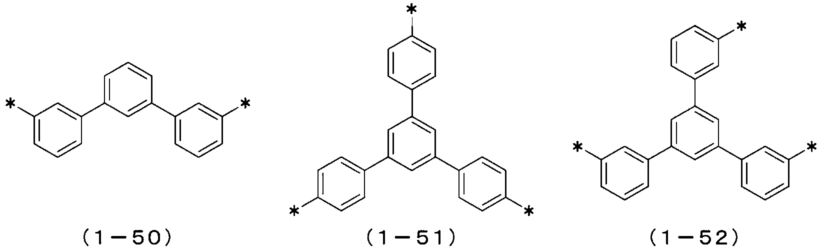

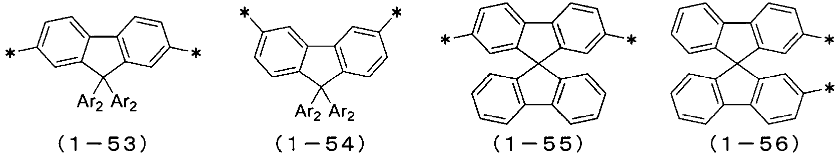

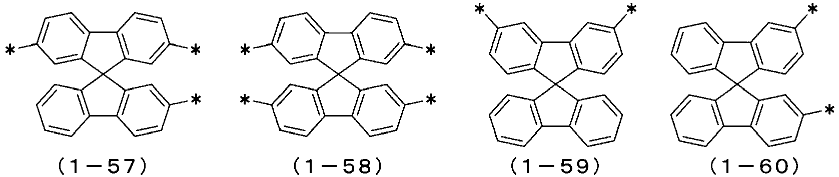

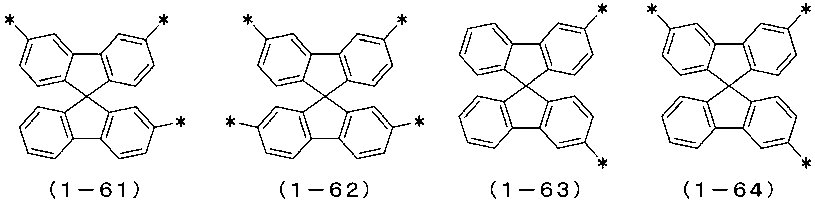

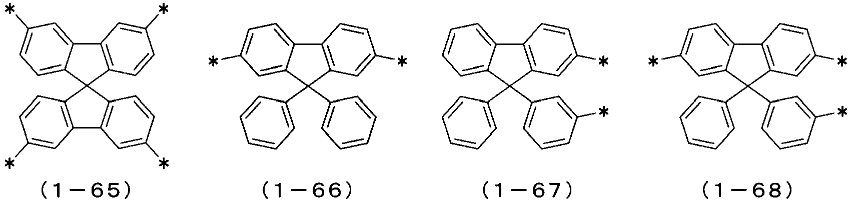

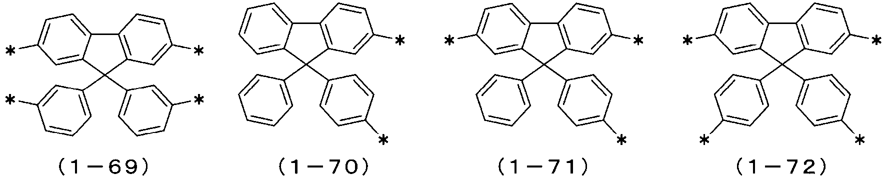

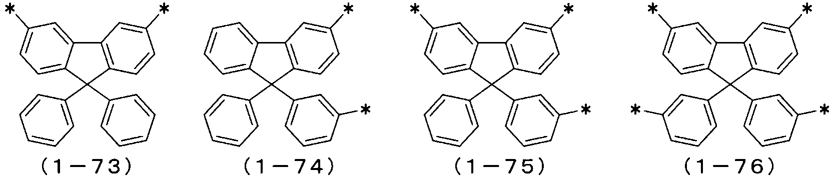

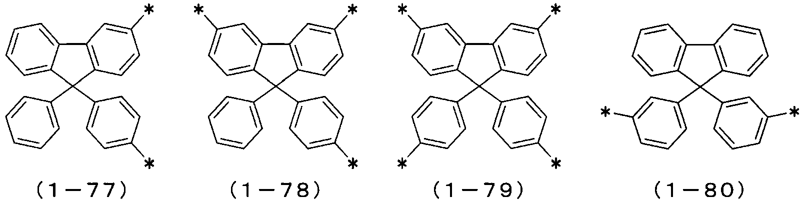

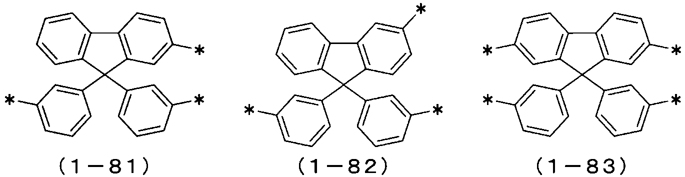

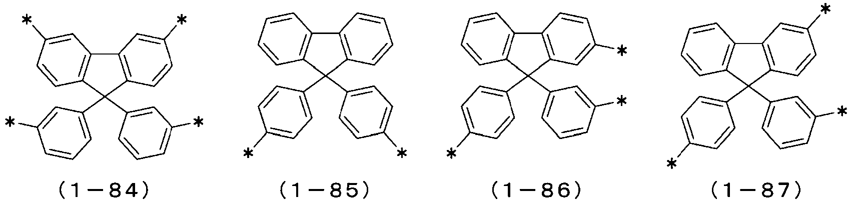

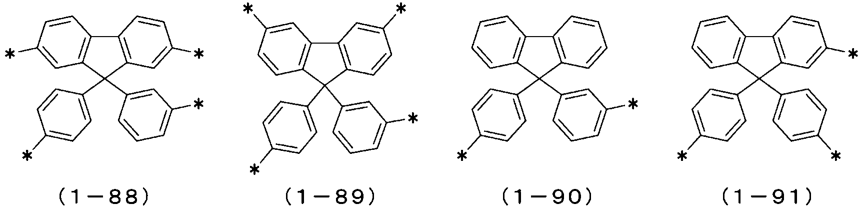

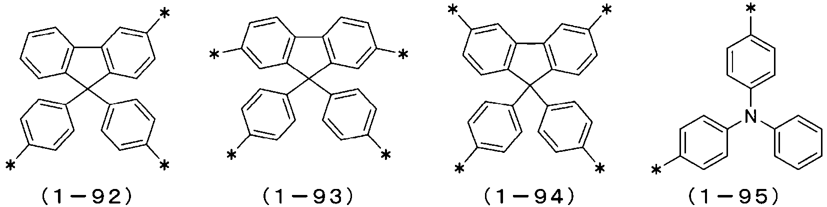

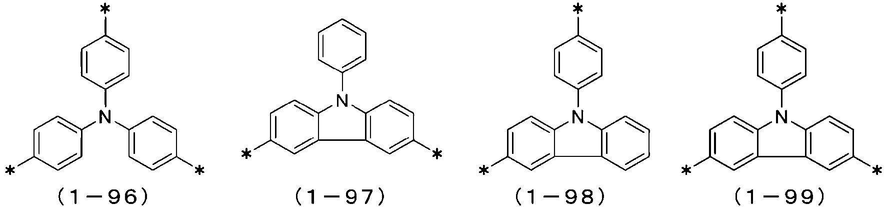

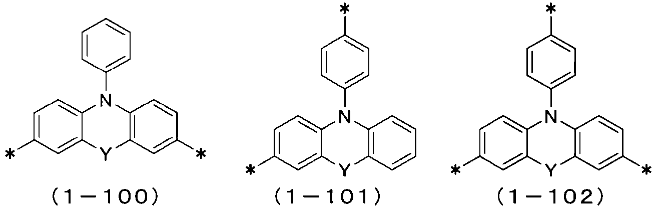

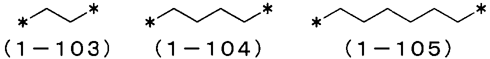

In chemical formulae (1-53) and (1-54), Ar₂ may each independently be a substituted or unsubstituted aromatic hydrocarbon group having 6 to 60 carbon atoms.

In formulae (1-100) to (1-102), Y may each independently be -O-, -S-, -C(CH₃)₂-, or a diphenylmethylene group.

In another example embodiment, X in Chemical Formula 1 may be selected from formula (1-34) or (1-36).

The followings are example compounds of Compound 1 to Compound 24, as the reactive organic compound included in the ink composition according to an embodiment. However, the reactive organic compound is not limited thereto.

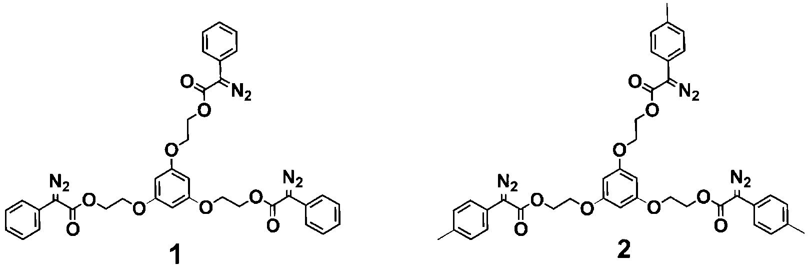

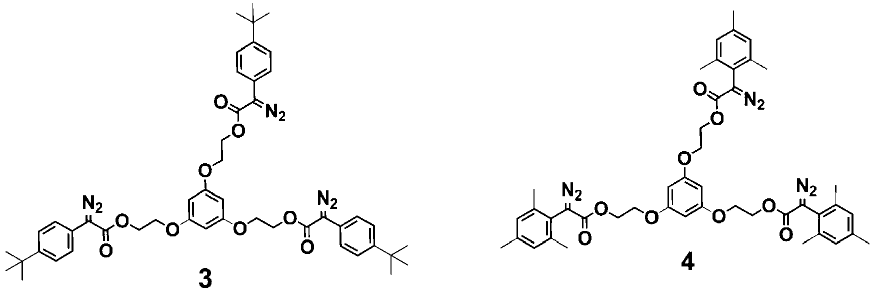

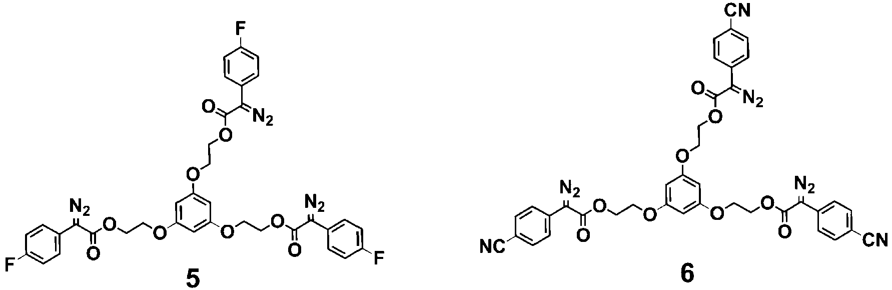

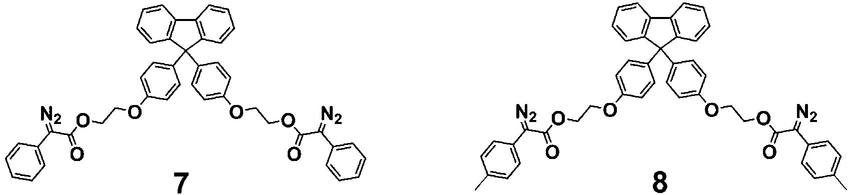

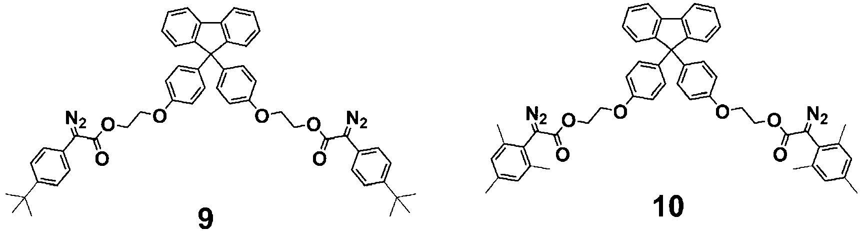

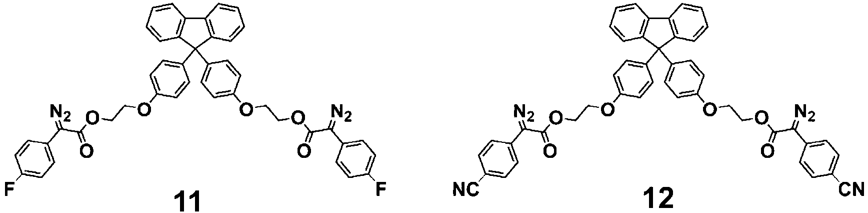

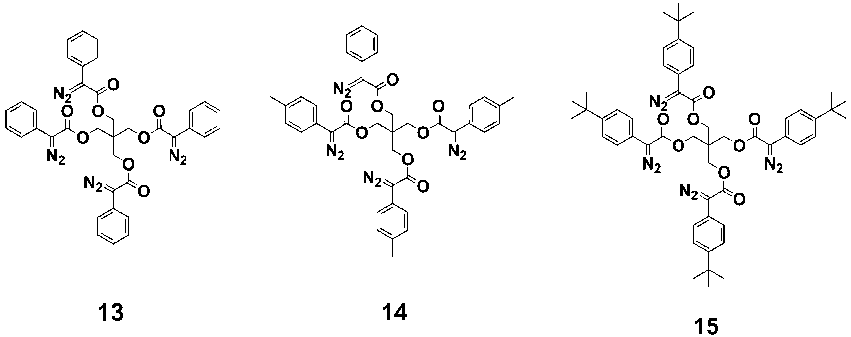

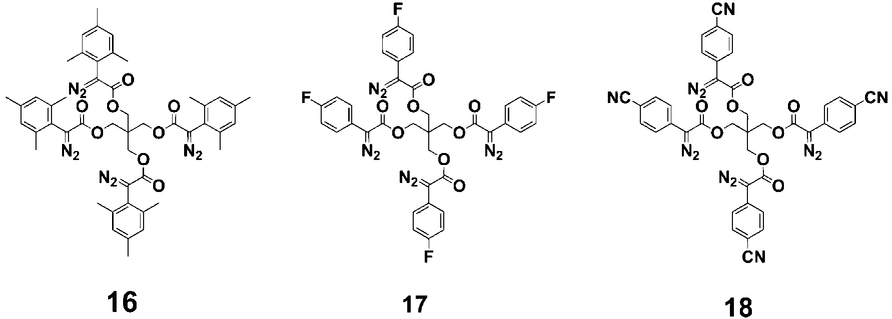

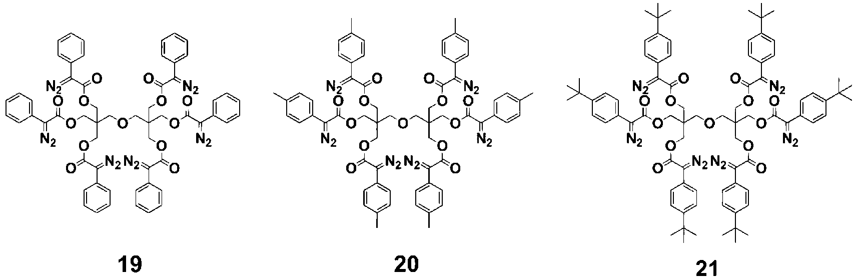

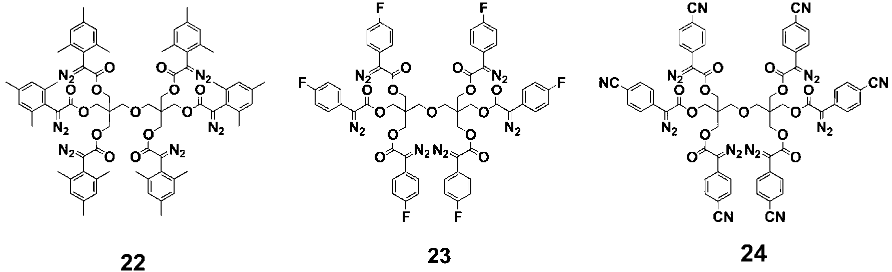

Among the above compounds, the reactive organic compound may include at least one selected from Compound 7, Compound 14, Compound 17, Compound 20, or Compound 23.

An amount of the reactive organic compound in the ink composition according to an embodiment may be greater than or equal to about 0.1 parts by weight and less than or equal to about 10.0 parts by weight, or, for example, greater than or equal to about 0.5 parts by weight and less than or equal to about 5 parts by mass or weight, with respect to 100 parts by weight of the quantum dot in the ink composition.

The reactive organic compound may be synthesized using known organic synthesis methods. For example, the compound may be synthesized using the methods described in the Examples or according to the methods described in the Examples. For example, the compound may be synthesized by changing the raw materials or reaction conditions, adding or excluding certain steps, or appropriately combining known synthesis methods in the methods described in the Examples.

The method for confirming the structure of the reactive organic compound is not particularly limited. The structure of a reactive organic compound may be confirmed, for example, by a known method, such as nuclear magnetic resonance (NMR), liquid chromatography-mass spectrometry (LC-MS), etc.

### Solvent

The ink composition according to an embodiment includes a solvent. The solvent includes at least one of the compounds represented by the following formulae (2) to (5). The solvent may be used alone or in combination of two or more. Commercially available or synthetic solvent may be used.

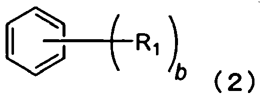

In the above formula (2), R₁ may be a linear or branched saturated hydrocarbon group having 1 to 18 carbon atoms, or a cyclic saturated hydrocarbon group having 3 to 12 carbon atoms, and b represents an integer of 1 to 3. When b is greater than or equal to 2, the types of the plurality of R₁ may be the same as or different from each other.

In the above formula (2), R₁ may be a linear or branched saturated hydrocarbon group having 1 to 10 carbon atoms, or a cyclic saturated hydrocarbon group having 3 to 6 carbon atoms.

In the above formula (2), the linear or branched saturated hydrocarbon group having 1 to 18 carbon atoms is not specifically limited. Examples of the linear or branched saturated hydrocarbon group having 1 to 18 carbon atoms may include methyl group, ethyl group, n-propyl group, n-butyl group, n-pentyl group, n-hexyl group, n-heptyl group, n-octyl group, n-nonyl group, n-decyl group, n-undecyl group, n-dodecyl group, n-tridecyl group, n-tetradecyl group, n-pentadecyl group, n-hexadecyl group, n-heptadecyl group, n-octadecyl group, isopropyl group, isobutyl group, sec-butyl group, tert-butyl group, isopentyl group, tert-pentyl group, neopentyl group, 1,2-dimethylpropyl group, isohexyl group, 1,3-dimethylbutyl group, 1-isopropylpropyl group, 1,2-dimethylbutyl group, 1,4-dimethylpentyl group, 3-ethylpentyl group, 2-methyl-1-isopropylpropyl group, 1-ethyl-3-methylbutyl group, 2-ethylhexyl group, 3-methyl-1-isopropylbutyl group, 2-methyl-1-isopropyl group, 1-tert-butyl-2-methylpropyl group, 3,5,5-trimethylhexyl group, isodecyl group, 1-methyldecyl group, etc.

In the above formula (2), the cyclic saturated hydrocarbon group having 3 to 12 carbon atoms is not particularly limited. Examples of the cyclic saturated hydrocarbon group having 3 to 12 carbon atoms may include cyclopropyl group, cyclobutyl group, cyclopentyl group, cyclohexyl group, cycloheptyl group, cyclooctyl group, cyclononyl group, cyclodecyl group, bicyclo[1.1.0]butyl group, bicyclo[1.1.1]pentyl group, bicyclo[2.1.0]pentyl group, bicyclo[3.1.0]hexyl group, bicyclo[2.1.1]hexyl group, bicyclo[2.2.0]hexyl group, bicyclo[2.2.1]heptyl group (norbornyl group), bicyclo[3.1.1]heptyl group, bicyclo[3.2.0]heptyl group, bicyclo[4.1.0]heptyl group, bicyclo[2.2.2]octyl group, bicyclo[3.2.1]octyl group, bicyclo[3.3.0]octyl group, bicyclo[4.1.1]octyl group, bicyclo[4.2.0]octyl group, bicyclo[5.1.0]octyl group, bicyclo[3.2.2]nonyl group, bicyclo[3.3.1]nonyl group, bicyclo[4.2.1]nonyl group, bicyclo[4.3.0]nonyl group, bicyclo[5.1.1]nonyl group, bicyclo[5.2.0]nonyl group, bicyclo[6.1.0]nonyl group, bicyclo[4.3.1]decyl group, tricyclo[5.2.1.02, 6]decyl group, isobornyl group, adamantyl group, etc.

Examples of the compound represented by formula (2) may include toluene, xylene, ethylbenzene, diethylbenzene, mesitylene, propylbenzene, cyclopropylbenzene, cyclopentylbenzene, cyclohexylbenzene, etc.

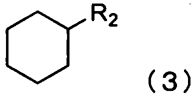

In the above formula (3), R₂ may be a linear or branched saturated hydrocarbon group having 1 to 18 carbon atoms, or a cyclic saturated hydrocarbon group having 3 to 12 carbon atoms.

In the above formula (3), the linear or branched saturated hydrocarbon group having 1 to 18 carbon atoms and the cyclic saturated hydrocarbon group having 3 to 12 carbon atoms may be the same as those of R₁.

In the above formula (3), R₂ may be a linear or branched saturated hydrocarbon group having 1 to 10 carbon atoms, or a cyclic saturated hydrocarbon group having 3 to 6 carbon atoms.

In the above formula (3), R₂ may be a linear or branched saturated hydrocarbon group having 6 to 10 carbon atoms, or a cyclic saturated hydrocarbon group having 3 to 6 carbon atoms.

Examples of the compound represented by formula (3) may include methylcyclohexane, ethylcyclohexane, n-butylcyclohexane, n-pentylcyclohexane, n-hexylcyclohexane, n-heptylcyclohexane, n-octylcyclohexane, n-nonylcyclohexane, n-decylcyclohexane, n-undecylcyclohexane, n-dodecylcyclohexane, n-tridecylcyclohexane, n-tetradecylcyclohexane, n-pentadecylcyclohexane, n-hexadecylcyclohexane, n-heptadecylcyclohexane, n-octadecylcyclohexane, isopropylcyclohexane, isobutylcyclohexane, sec-butylcyclohexane, tert-butylcyclohexane, isopentylcyclohexane, tert-pentylcyclohexane, neopentylcyclohexane, 1,2-dimethylpropylcyclohexane, isohexylcyclohexane, 1,3-dimethylbutylcyclohexane, 1-isopropylpropylcyclohexane, 1,2-dimethylbutylcyclohexane, 1,4-dimethylpentylcyclohexane, 3-ethylpentylcyclohexane, 2-methyl-1-isopropylpropylcyclohexane, 1-ethyl-3-methylbutylcyclohexane, 2-ethylhexylcyclohexane, 3-methyl-1-isopropylbutylcyclohexane, 2-methyl-1-isopropylcyclohexane, 1-tert-butyl-2-methylpropylcyclohexane, 3,5,5-trimethylhexylcyclohexane, isodecylcyclohexane, 1-methyldecylcyclohexane, etc.

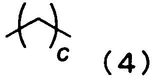

In the above formula (4), c may represent an integer of greater than or equal to 6 and less than or equal to 18.

Examples of the compound represented by formula (4) may include n-octane, n-nonane, n-decane, n-undecane, n-dodecane, n-tridecane, n-tetradecane, n-pentadecane, n-hexadecane, n-heptadecane, n-octadecane, n-nonadecane, n-eicosane, etc.

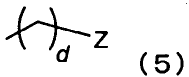

In the above formula (5), Z may represent -OH, -COOH, -NH₂-, or -SH, and d may represent an integer of greater than or equal to 7 and less than or equal to 17.

Examples of the compound represented by formula (5) may include n-octanol, n-nonanol, n-decanol, n-undecanol, n-dodecanol, n-tridecanol, n-tetradecanol, n-pentadecanol, n-hexadecanol, n-heptadecanol, n-octadecanol; nonanoic acid, decanoic acid, undecanoic acid, dodecanoic acid, tridecanoic acid, tetradecanoic acid, pentadecanoic acid, hexadecanoic acid, heptadecanoic acid, octadecanoic acid, nonadecanoic acid; n-octylamine, n-nonylamine, n-decyl amine, n-undecylamine, n-dodecylamine, n-tridecylamine, n-tetradecylamine, n-pentadecylamine, n-hexadecylamine, n-heptadecylamine, n-octadecylamine; 1-octanethiol, 1-nonanethiol, 1-decanethiol, 1-undecanethiol, 1-dodecanethiol, 1-tridecanethiol, 1-tetradecanethiol, 1-pentadecanethiol, 1-hexadecanethiol, 1-heptadecanethiol, 1-octadecanethiol, etc.

The amount of the solvent may be appropriately set to satisfy the amount of the quantum dots and reactive organic compound described above.

### Additives

The ink composition according to an embodiment may, if necessary, include various additives. Examples of the additives include, for example, a host material used in the light-emitting layer, an antioxidant, a leveling agent, a plasticizer, a surfactant, an antifoaming agent, a silane coupling agent, an ultraviolet absorber, an adhesion promoter, etc.

Examples of the host material may include, for example, compounds having a carbazole skeleton, compounds having a diarylamine skeleton, compounds having a pyridine skeleton, compounds having a pyrazine skeleton, compounds having a triazine skeleton, compounds having an arylsilane skeleton, etc.

The amount of the additive in the ink composition may be appropriately determined depending on the intended use, within a range that does not impair the purpose of an embodiment.

As long as the purpose of an embodiment is not impaired, the ink composition according to an embodiment may further include other solvents than the above solvent. Examples of such other solvents may include (+)-limonene, ethylene glycol monobutyl ether, α-terpineol, propylene carbonate, dimethyl sulfoxide, N,N-dimethylformamide, 1-bromooctane, 1-bromononane, 1-bromodecane, 1-bromododecane, etc. The amount of these other solvents may be 10 parts by volume or less, for example, 5 parts by volume or less, based on 100 parts by volume of the solvent. In an example embodiment, the amount of the other solvents may be 0 parts by volume, i.e., no solvents other than the solvent according to an embodiment may be included.

### Method for Preparing Ink Composition

A method for preparing the ink composition according to an embodiment is not particularly limited. For example, quantum dots, reactive organic compound, solvent, and other components added as needed may be mixed at once, or a method of sequentially mixing each component may be used. The temperature at the time of mixing is not particularly limited, but may be, for example, in the range of about 20 °C to about 30 °C. Also, the mixing time is not particularly limited, but may be, for example, in the range of about 0.1 hour to about 1 hour.

### Use

The ink composition according to an embodiment is not particularly limited with respect to use, but may be, for example, be used for forming a quantum dot-containing layer of various optical members in a display device and the like. In addition, the ink composition according to an embodiment is suitable for forming the quantum dot-containing layer using an inkjet process, or, for example, may be used for inkjet process. The optical members may include, for example, a semiconductor optical member such as a light conversion member, a light emitting member, and the like.

For example, the ink composition according to an embodiment may be used to form a light emitting layer of an electroluminescent device. Another embodiment provides an electroluminescent device, i.e., a quantum dot electroluminescent device, having a light emitting layer formed of the ink composition. In a still another embodiment, an image display device having the above-described electroluminescent device (i.e., a quantum dot electroluminescent device) is provided.

Hereinafter, quantum dot electroluminescent device will be described in detail.

Referring to FIG. 1, a quantum dot electroluminescent device according to an embodiment will be described in detail. FIG. 1 is a schematic representation showing a quantum dot electroluminescent device according to an embodiment. In the present specification, "quantum dot electroluminescent device" may be abbreviated as "QLED."

As shown in FIG. 1, the QLED 100 according to an embodiment includes a substrate 110, a first electrode 120 on the substrate 110, a hole injection layer 130 on the first electrode 120, a hole transport layer 140 on the hole injection layer 130, a light emitting layer 150 on the hole transport layer 140, an electron transport layer 160 on the light emitting layer 150, an electron injection layer 170 on the electron transport layer 160, and a second electrode 180 on the electron injection layer 170.

The film formation method of layers other than the light emitting layer 150 is not particularly limited. The layers other than the light emitting layer 150 may be formed by, for example, a vacuum deposition method or a solution application method using methods well known to those of ordinary skill in the relevant art as follows. Examples of the solution application method may include a spin coat method, a casting method, a micro gravure coating method, a gravure coating method, a bar coat method, a roll coating method, a wire bar coat method, a dip coat method, a spray coat method, a screen-printing method, a flexographic printing method, an offset printing method, an inkjet printing method, and the like.

When the layers other than the light emitting layer 150 are formed by a solution application method, examples of the solvent used may include toluene, xylene, ethyl benzene, diethylbenzene, mesitylene, propyl benzene, cyclohexyl benzene, dimethoxy benzene, anisole, ethoxy toluene, phenoxy toluene, isopropyl biphenyl, dimethyl anisole, phenyl acetate, phenyl propionate, methyl benzoate, ethyl benzoate, cyclohexane, and the like. An amount of solvent used in the coating liquid is not particularly limited.

As the substrate 110, a substrate used in general EL devices may be used. For example, the substrate 110 may be a semiconductor substrate such as a glass substrate or a silicon substrate, or a transparent plastic substrate.

A first electrode 120 is formed on the substrate 110. The first electrode 120 may be, for example, an anode, and may be formed of a metal, an alloy, or a conductive compound having a large work function. For example, the first electrode 120 may be made of indium tin oxide (In₂O₃-SnO₂:ITO), indium zinc oxide (In₂O₃-ZnO), tin oxide (SnO₂), zinc oxide (ZnO), etc., which have improved transparency and conductivity, as a transmissive electrode. The first electrode 120 may be formed as a reflective electrode by laminating magnesium (Mg), aluminum (Al), or the like on the transparent conductive film. In addition, after forming the first electrode 120 on the substrate 110, cleaning and ultraviolet (UV)-ozone treatment may be performed, if necessary.

A hole injection layer 130 is formed on the first electrode 120. The hole injection layer 130 may be a layer that facilitates hole injection from the first electrode 120 and may be formed with the following thickness (dry film thickness; hereinafter the same), for example, greater than or equal to about 10 nm and less than or equal to about 1000 nm, for example, greater than or equal to about 20 nm and less than or equal to about 300 nm.

The hole injection layer 130 may be formed of a known hole injection material. The known hole injection material forming the hole injection layer 130 may be, for example triphenylamine-containing polyether ketone (poly(ether ketone)-containing triphenylamine: TPAPEK), 4-isopropyl-4'-methyldiphenyliodonium tetrakis( pentafluorophenyl)borate (PPBI), N,N'-diphenyl-N,N'-bis-[4-(phenyl-m-tolyl-amino)-phenyl]-biphenyl-4,4'-diamine (DNTPD), copper phthalocyanine, 4,4',4"-tris(3-methylphenylphenylamino)triphenylamine (m-MTDATA), N,N'-di(1-naphthyl)-N,N'-diphenylbenzidine (NPB), 4,4',4"-tris(diphenylamino) triphenylamine (TDATA), 4,4',4"-tris(N, N-2-naphthylphenylamino)triphenylamine (2-TNATA), polyaniline/dodecylbenzenesulfonic acid, poly(3,4-ethylenedioxythiophene)/poly(4-styrenesulfonate) (PEDOT/PSS), polyaniline/10-camphorsulfonic acid, and the like, but is not limited thereto.

The hole transport layer 140 is formed on the hole injection layer 130. The hole transport layer 140 is a layer having a function of transporting holes, and may be formed to a thickness of, for example, greater than or equal to about 10 nm and less than or equal to about 150 nm, for example, greater than or equal to about 20 nm and less than or equal to about 50 nm.

The hole transport layer 140 may be formed of a known hole transport material. The known hole transport material may be, for example, 1,1-bis[(di-4-tolylamino)phenyl]cyclohexane (TAPC), a carbazole derivative such as N-phenyl carbazole and polyvinyl carbazole, N,N'-bis (3-methylphenyl)-N,N'-diphenyl-[1,1-biphenyl]-4,4'-diamine (TPD), 4,4',4"-tris(N-carbazolyl) triphenylamine (TCTA), N,N'-di(1-naphthyl)-N,N'-diphenylbenzidine (NPB), poly[ (9,9-dioctylfluoren-2,7-diyl)-co-(4,4'-(N-(4-sec-butylphenyl)diphenylamine) (TFB), and the like, but is not limited thereto. These hole transport materials may be used alone or as a mixture of two or more.

The light emitting layer 150 is formed on the hole transport layer 140. The light emitting layer 150 includes quantum dots, and, as described above, may be formed by using, for example, an inkjet printing process using an ink composition according to an embodiment. An embodiment provides an electroluminescent device (quantum dot electroluminescent device) having a light-emitting layer formed by an inkjet device using an ink composition according to an embodiment. Another embodiment provides a quantum dot electroluminescent device having a light-emitting layer formed by using an ink composition according to an embodiment, wherein the light-emitting layer may be formed by an inkjet device. The light emitting layer 150 may be formed to a thickness of, for example, greater than or equal to about 10 nm and less than or equal to about 60 nm, for example, greater than or equal to about 20 nm and less than or equal to about 50 nm.

Because the ink composition according to an embodiment has a relatively high surface tension together with a relatively high viscosity, the light emitting layer formed therefrom has good or an acceptable flatness, particularly, acceptable flatness as deposited into a bank substrate. As an example, the flatness may be, for example, greater than or equal to about 55%, for example, greater than or equal to about 60%. The upper limit of flatness is 100%.

In an embodiment, the flatness of the light emitting layer may be greater than or equal to about 55% and less than or equal to about 100%, for example, greater than or equal to about 60% and less than or equal to about 100%. The flatness is a value measured by the method described in examples.

The electron transport layer 160 is formed on the light emitting layer 150. The electron transport layer 160 is a layer having a function of transporting electrons, and may be formed using a vacuum deposition method, a spin coating method, an inkjet method, or the like. The electron transport layer 160 may be formed with a thickness of, for example, greater than or equal to about 15 nm and less than or equal to about 50 nm.

The electron transport layer 160 may be formed using a known electron transport material. The electron transport material may be an organic material or an inorganic material. The known organic electron transport material may be, for example, (8-) lithium (lithium quinolate) (Liq), tris (8-) aluminum (tris (8-quinolinato) aluminum: Alq3), and a compound having a nitrogen-containing aromatic ring.

Specific example of the compound having a nitrogen-containing aromatic ring may be, for example, a compound containing a pyridine ring such as 1,3,5-tri[(3-pyridyl)-phen-3-yl]benzene, a compound containing a triazine ring such as 2,4,6-tris(3'-(pyridin-3-yl)biphenyl-3-yl)-1,3,5-triazine, a compound containing an imidazole ring such as 2-(4-(N-phenylbenzoimidazolyl-1-yl-phenyl)-9,10-dinaphthylanthracene, 1,3,5-tris(N-phenyl-benzimidazol-2-yl)benzene (TPBI), and, but are not limited thereto.

In addition, the known inorganic electron transport material is not particularly limited, and examples thereof may include oxides such as TiO₂, ZnO, ZnMgO, SiO₂, SnO₂, WO₃, Ta₂O₃, BaTiO₃, BaZrO₃, ZrO₂, HfO₂, Al₂O₃, Y₂O₃, ZrSiO₄, and the like. The electron transport material may be used alone or in combination of two or more.

The electron injection layer 170 is formed on the electron transport layer 160. The electron injection layer 170 is a layer having a function of facilitating injection of electrons from the second electrode 180.

The electron injection layer 170 may be formed using a vacuum deposition method or the like. The electron injection layer 170 may have a thickness of greater than or equal to about 0.1 nm and less than or equal to about 5 nm, for example, greater than or equal to about 0.3 nm and less than or equal to about 2 nm.

Any known material for forming the electron injection layer 170 may be used. For example, the electron injection layer 170 may include lithium compounds such as (8-)lithium (lithium quinolate) ((8-quinolinato)lithium: Liq) and lithium fluoride (LiF), sodium chloride (NaCl), cesium fluoride (CsF), lithium oxide (Li₂O), or barium oxide (BaO).

The second electrode 180 is formed on the electron injection layer 170. The second electrode 180 may be formed using a vacuum deposition method or the like.

The second electrode 180 is, specifically, a cathode, and may be formed of a metal, an alloy, or a conductive compound having a low work function. For example, the second electrode 180 may be formed of a metal such as lithium (Li), magnesium (Mg), aluminum (Al), or calcium (Ca), or an alloy such as aluminum-lithium (Al-Li), magnesium-indium (Mg-In), or magnesium-silver (Mg-Ag), as a reflective electrode.

The second electrode 180 may be formed to a thickness of greater than or equal to about 10 nm and less than or equal to about 200 nm, for example, greater than or equal to about 50 nm and less than or equal to about 150 nm.

Alternatively, the second electrode 180 may be formed as a transmissive electrode by using a thin film of less than or equal to about 20 nm of the metal material, a transparent conductive film such as indium tin oxide (In₂O₃-SnO₂) or indium zinc oxide (In₂O₃-ZnO).

Meanwhile, the stacked structure of the QLED 100 according to the present embodiment is not limited to the above embodiment.

The QLED 100 according to this embodiment may be formed in other known laminated structures. For example, in the QLED 100, one or more layers of the hole injection layer 130, the hole transport layer 140, the electron transport layer 160, and the electron injection layer 170 may be omitted, and other layers may be further added.

In addition, each layer of the QLED 100 may be formed as a single layer, or may be formed as a plurality of layers. For example, the QLED 100 may further include a hole blocking layer between the electron transport layer 160 and the light emitting layer 150 to prevent diffusion of excitons or holes into the electron transport layer 160. The hole blocking layer may be formed of, for example, an oxadiazole derivative, a triazole derivative, or a phenanthroline derivative.

While the embodiments of the present invention have been described in detail, they are illustrative and exemplary, not limiting, and it is clear that the scope of the present invention should be interpreted in accordance with the appended claims. The present invention includes the following embodiments.
1. An ink composition including a plurality of quantum dots, a reactive organic compound, and a solvent, wherein the plurality of quantum dots do not include cadmium (Cd) or lead (Pb), and the reactive organic compound is represented by Chemical Formula 1: 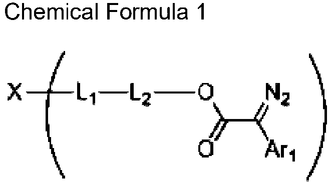 in Chemical Formula 1,
   Ar₁ is a substituted or unsubstituted aromatic hydrocarbon group having 6 to 60 carbon atoms,
   L₁ is a single bond or an oxygen atom,
   L₂ is a single bond, a substituted or unsubstituted saturated hydrocarbon group having 1 to 60 carbon atoms, or a substituted or unsubstituted aromatic hydrocarbon group having 6 to 60 carbon atoms, and
   X is a group selected from the groups represented by the following formulae (1-1) to (1-37): 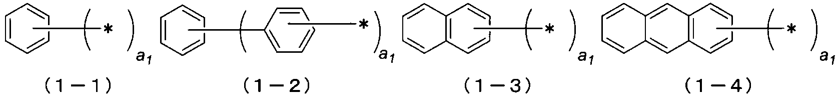 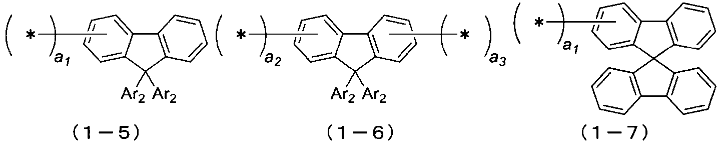 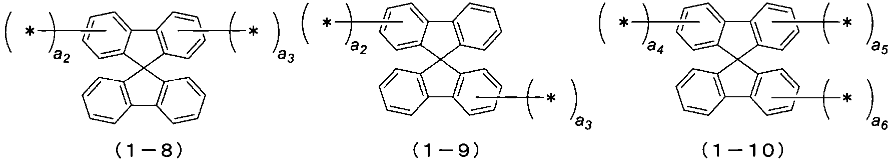 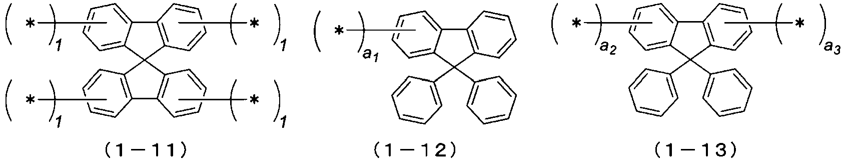 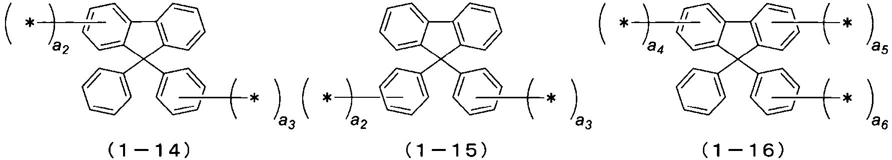 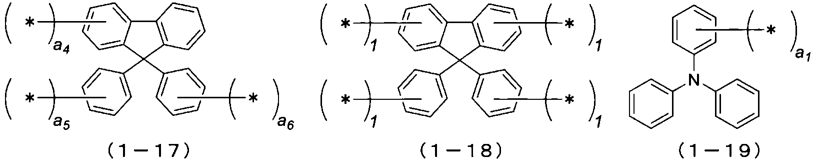 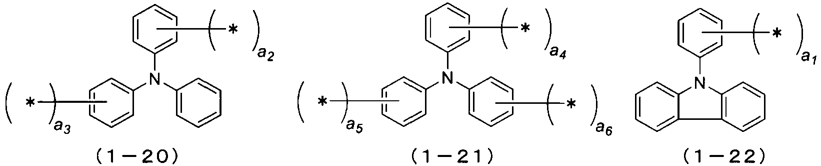 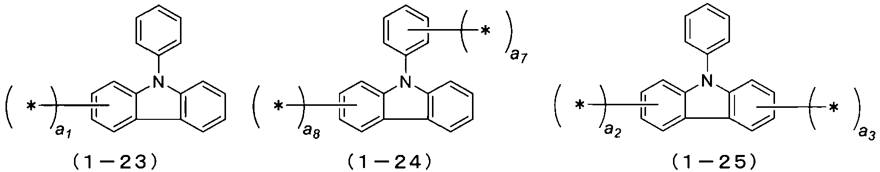 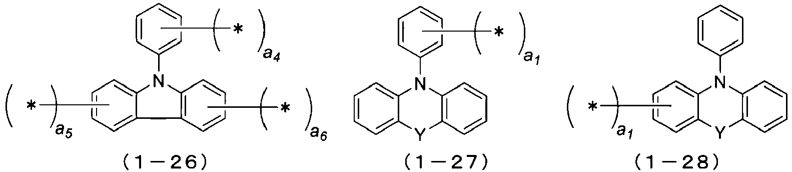 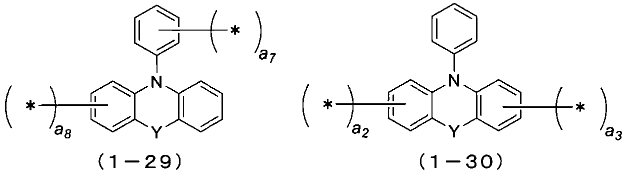 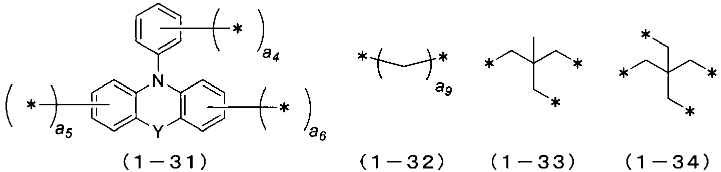 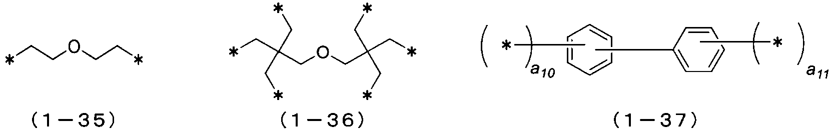
   in formulae (1-1) to (1-37), * represents a binding site,
   in formulae (1-1) to (1-5), (1-7), (1-12), (1-19), (1-22), (1-23), (1-27), and (1-28), a1 independently represents an integer of greater than or equal to 2 and less than or equal to 4,
   in the above formulae (1-6), (1-8), (1-9), (1-13) to (1-15), (1-20), (1-25), and (1-30), a2 independently represents an integer of greater than or equal to 1 and less than or equal to 3, a3 independently represents 1 or 2, and the sum of a2 and a3 is independently 2, 3, or 4,
   in formulae (1-10), (1-16), (1-17), (1-21), (1-26), and (1-31), a4 independently represents 1 or 2, a5 independently represents 1, a6 independently represents 1 or 2, and the sum of a4, a5, and a6 independently represents 3 or 4,
   in formulae (1-24) and (1-29), a7 independently represents an integer of greater than or equal to 1 and less than or equal to 3, a8 independently represents an integer of greater than or equal to 1 and less than or equal to 3, and the sum of a7 and a8 independently represents 2, 3, or 4,
   in formula (1-32), a9 is an integer of greater than or equal to 2 and less than or equal to 18,
   in formula (1-37), a10 represents 1 or 2, and a11 represents 1 or 2,
   in formulae (1-5) and (1-6), Ar₂ is each independently a substituted or unsubstituted aromatic hydrocarbon group having 6 to 60 carbon atoms, and
   in formulae (1-27) to (1-31), Y is each independently -O-, -S-, -C(CH3)2-, or a diphenylmethylene group.
2. The ink composition described in item 1, wherein the solvent comprises a compound represented by any one of the following formulae (2) to (5): 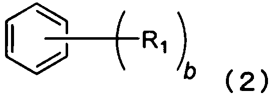 In formula (2),
   R₁ is a linear or branched saturated hydrocarbon group having 1 to 18 carbon atoms, or a cyclic saturated hydrocarbon group having 3 to 12 carbon atoms, and
   b represents an integer of 1 to 3; 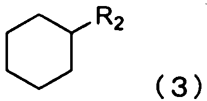
   In formula (3),
   R₂ is a linear or branched saturated hydrocarbon group having 1 to 18 carbon atoms, or a cyclic saturated hydrocarbon group having 3 to 12 carbon atoms; 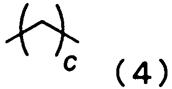
   In formula (4),
   c represents an integer of greater than or equal to 6 and less than or equal to 18; and 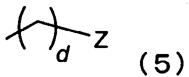
   In formula (5),
   Z represents -OH, -COOH, -NH₂-, or -SH, and
   d represents an integer of greater than or equal to 7 and less than or equal to 17.
3. The ink composition described in any of items 1 and 2, wherein an average particle diameter of the plurality of quantum dots is from about 1 nm to about 15 nm.
4. The ink composition described in any of items 1 to 3, wherein an amount of the plurality of quantum dots is about 0.1 wt% to about 10.0 wt% based on a total weight of the ink composition.
5. The ink composition described in any of items 1 to 4, wherein an amount of the reactive organic compound is about 0.1 parts by weight to about 10.0 parts by weight with respect to 100 parts by weight of the quantum dots in the ink composition.
6. The ink composition described in any of items 1 to 5, wherein the X in Chemical Formula 1 is a group selected from the groups represented by the following formulae (1-38) to (1-105): 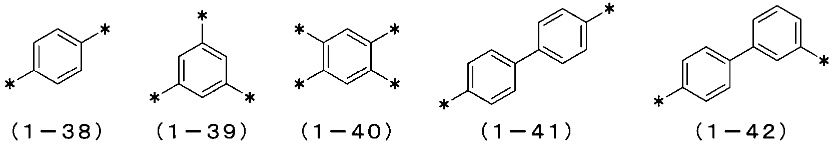 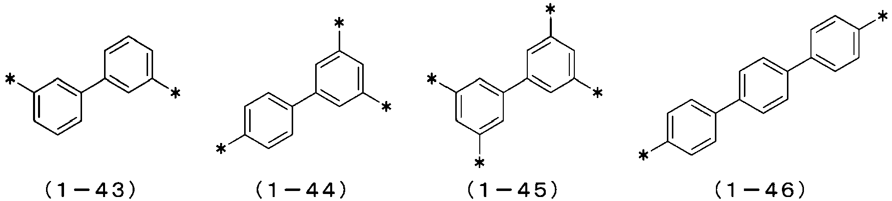 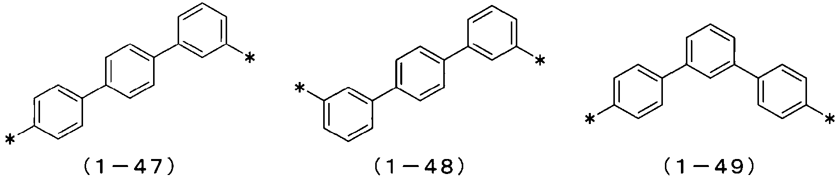 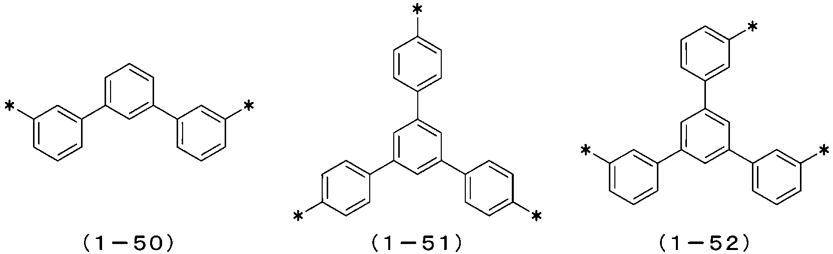 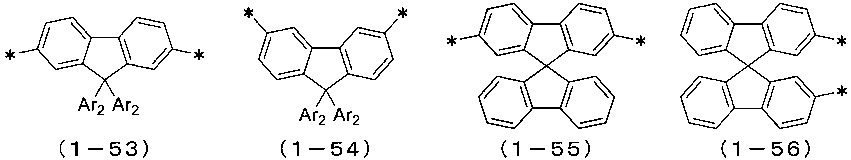 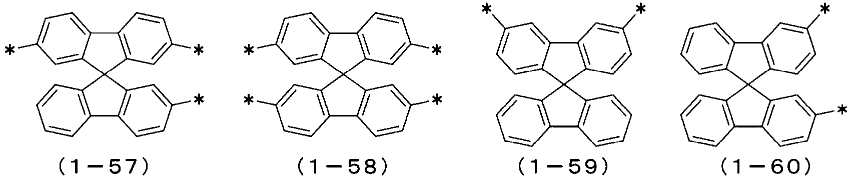 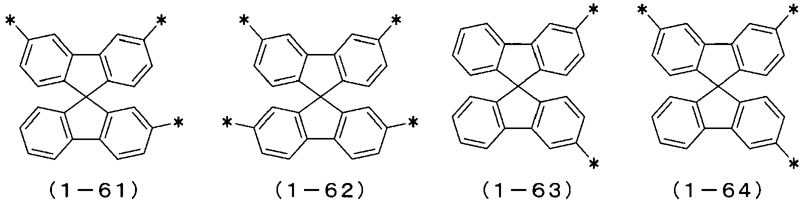 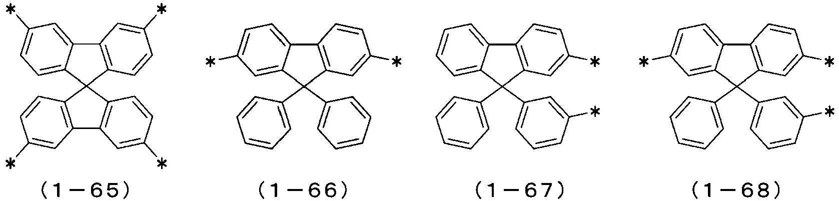 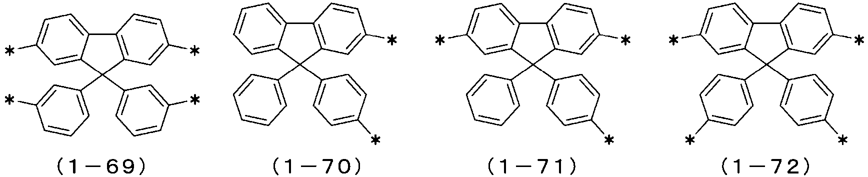 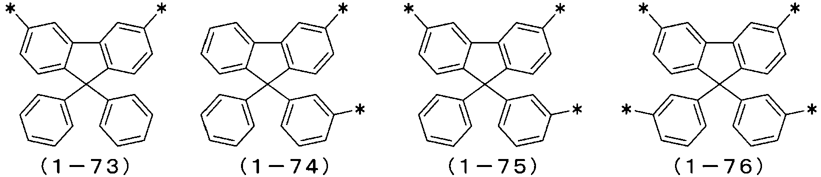 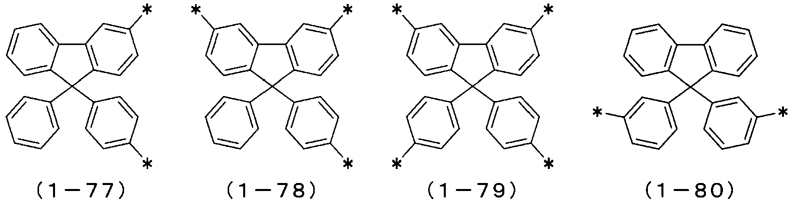 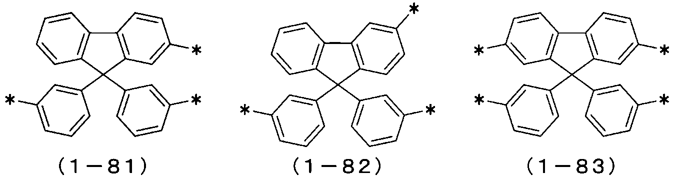 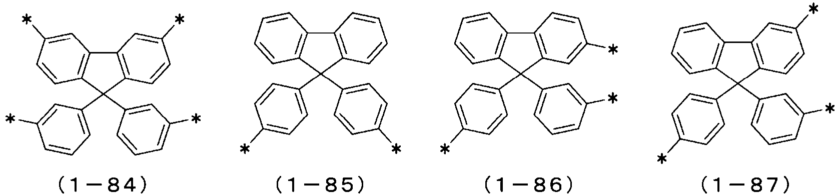 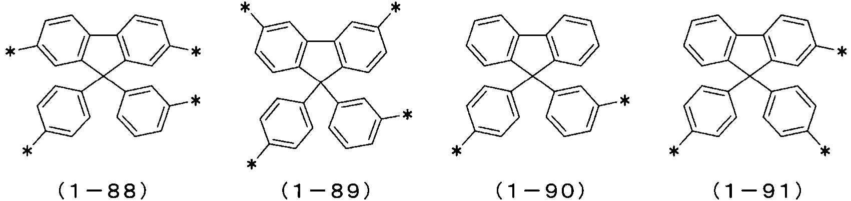 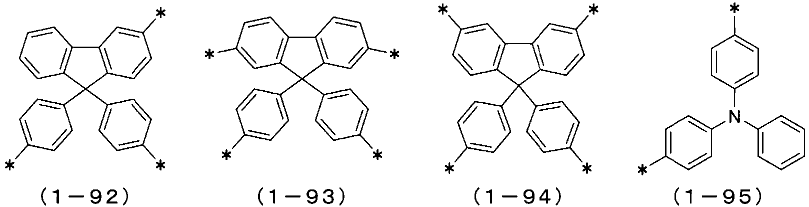 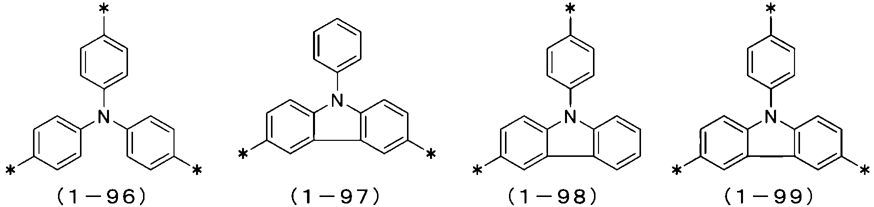 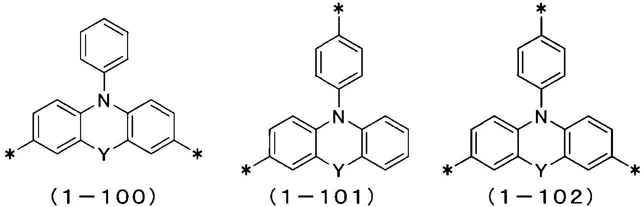 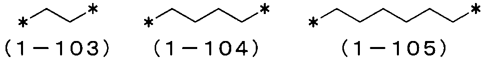
   in chemical formulae (1-53) and (1-54), Ar₂ may each independently be a substituted or unsubstituted aromatic hydrocarbon group having 6 to 60 carbon atoms, and
   in formulae (1-100) to (1-102), Y may each independently be -O-, -S-, -C(CH₃)₂-, or a diphenylmethylene group.
7. The ink composition described in any of items 1 to 6, wherein the X in Chemical Formula 1 is selected from formula (1-34) or formula (1-36).
8. The ink composition described in any of items 1 to 7, wherein the reactive organic compound is represented by Compound 1 to Compound 24. 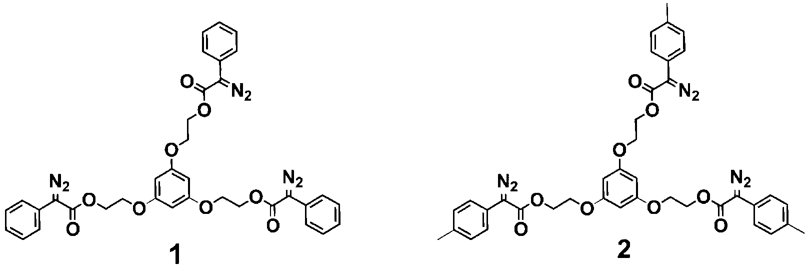 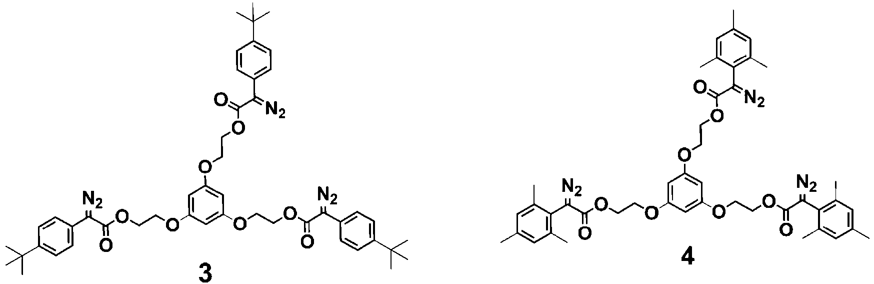 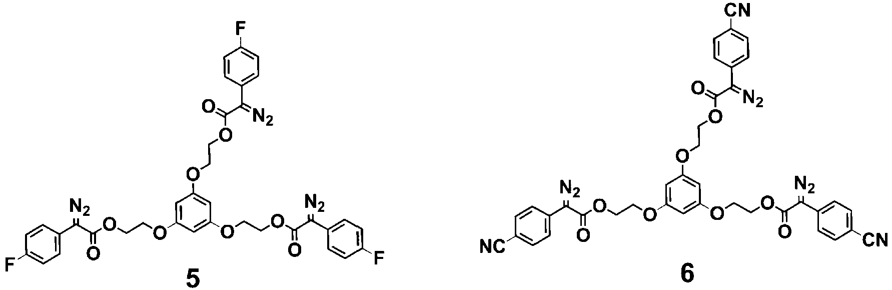 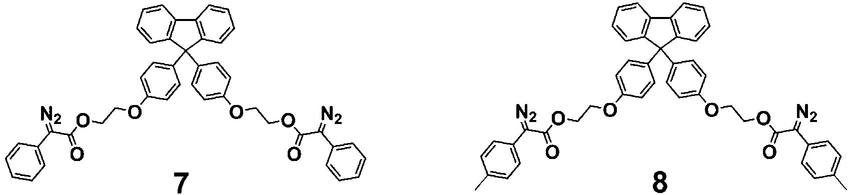 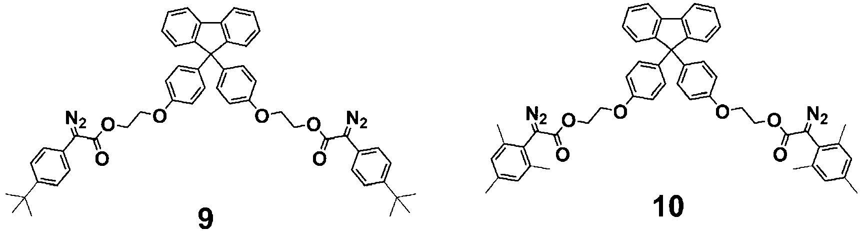 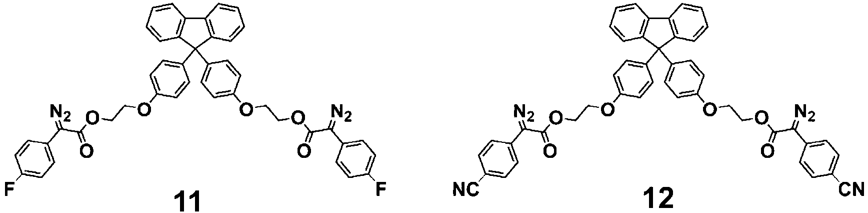 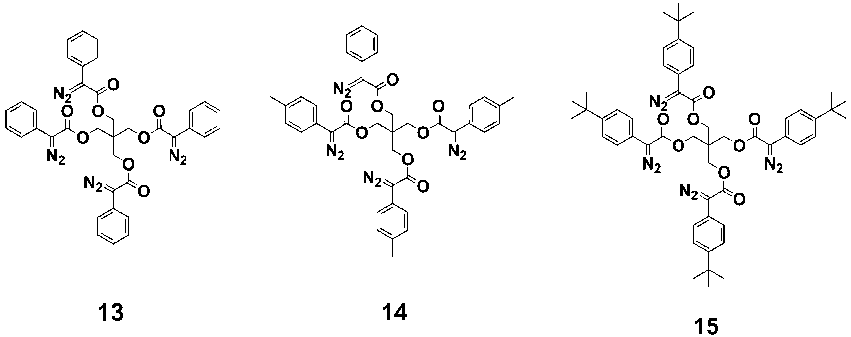 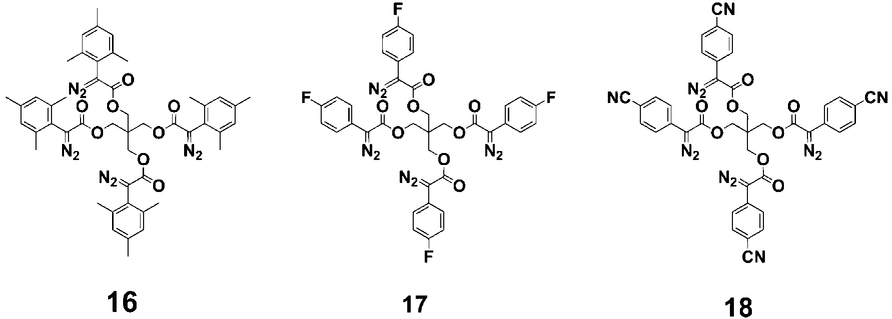 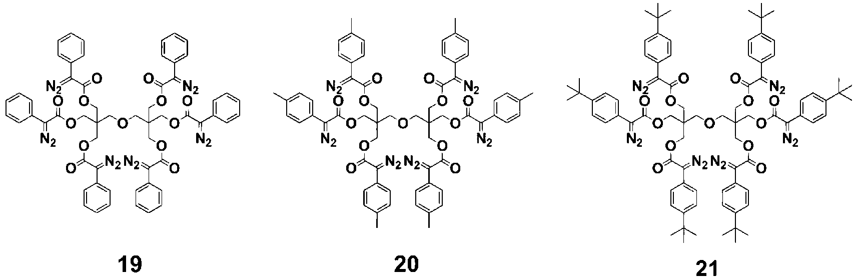 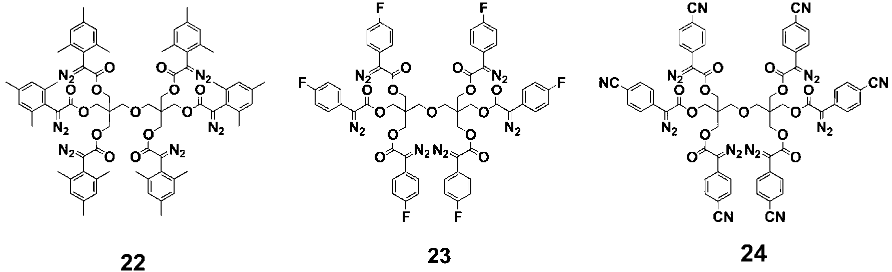
9. The ink composition described in any of items 1 to 8, wherein the reactive organic compound is represented by any one of Compound 7, Compound 14, Compound 20, Compound 23, or a combination thereof.
10. The ink composition described in any of items 1 to 9, wherein R₁ of formula (2) is a linear or branched saturated hydrocarbon group having 1 to 10 carbon atoms, or a cyclic saturated hydrocarbon group having 3 to 6 carbon atoms.
11. The ink composition described in any of items 1 to 10, wherein R₂ of formula (3) is a linear or branched saturated hydrocarbon group having 6 to 10 carbon atoms, or a cyclic saturated hydrocarbon group having 3 to 6 carbon atoms.
12. The ink composition described in any of items 1 to 11, wherein a surface of the plurality of quantum dots is coordinated by an organic ligand selected from a halogenated alkyl compound, a mercapto group-containing compound, an aliphatic carboxylic acid compound, or a combination thereof of.
13. The ink composition described in any of items 1 to 12, wherein an amount of the organic ligand is greater than or equal to about 1 part by weight and less than or equal to about 30 parts by weight, with respect to 100 parts by weight of the plurality of quantum dots.
14. A quantum dot electroluminescent device including a light emitting layer formed from the ink composition described in any of items 1 to 13.
15. A quantum dot electroluminescent device including a light emitting layer formed from the ink composition described in any of items 1 to 13, wherein the light emitting layer is formed by using an inkjet device.
16. An image display device including the quantum dot electroluminescent device described in any of item 14 or item 15.
17. A method of fabricating a quantum dot electroluminescent device, the quantum dot electroluminescent device including a light emitting layer formed from the ink composition described in any one of items 1 to 13, wherein the light emitting layer is formed by using an inkjet device.

### Examples

The embodiments will be described in more detail using the following examples and comparative examples, but the technical scope of the embodiment is not limited only to the following examples.

### Synthesis Example 1: Synthesis of Compound 7

Compound 7 is synthesized as described in Reaction Scheme 1 below:

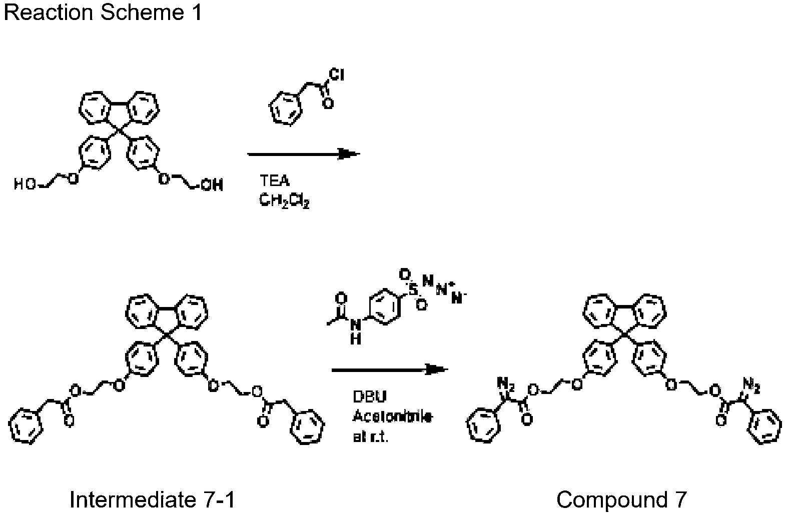

A mixture of 9,9-bis[4-(2-hydroxyethoxy)phenyl]fluorene (5.0 grams (g)), triethylamine (4.6 g), and dichloromethane (80 milliliters (mL)) were ice-cooled, and phenylacetyl chloride (5.3 g) was added dropwise over 30 minutes thereto. The mixture was stirred at room temperature for 24 hours to complete the reaction. The reaction mixture was extracted three times with dichloromethane, and the organic solvent was distilled off. The crude product was purified by silica gel chromatography (eluent: ethyl acetate/hexane) to obtain intermediate 7-1 as a viscous liquid (7.28 g, yield 94, 6%).

In a 300 mL three-necked flask, intermediate 7-1 (3.64 g), diazabicycloundecene (3.3 g), and acetonitrile (100 mL) were placed, and p-acetamidebenzenesulfonyl azide (5.2 g) was added slowly in portions. The mixture was stirred at room temperature for 24 hours under a nitrogen atmosphere. After completion of the reaction, the resulting mixture was poured into water, extracted with dichloromethane, and the organic solvent was distilled off. The crude product was purified by silica gel chromatography (eluent: dichloromethane) to obtain Compound 7 (2.32 g, yield 59.2%).

### Synthesis Example 2: Synthesis of Compound 14

Compound 14 was synthesized as described in Reaction Scheme 2 below.

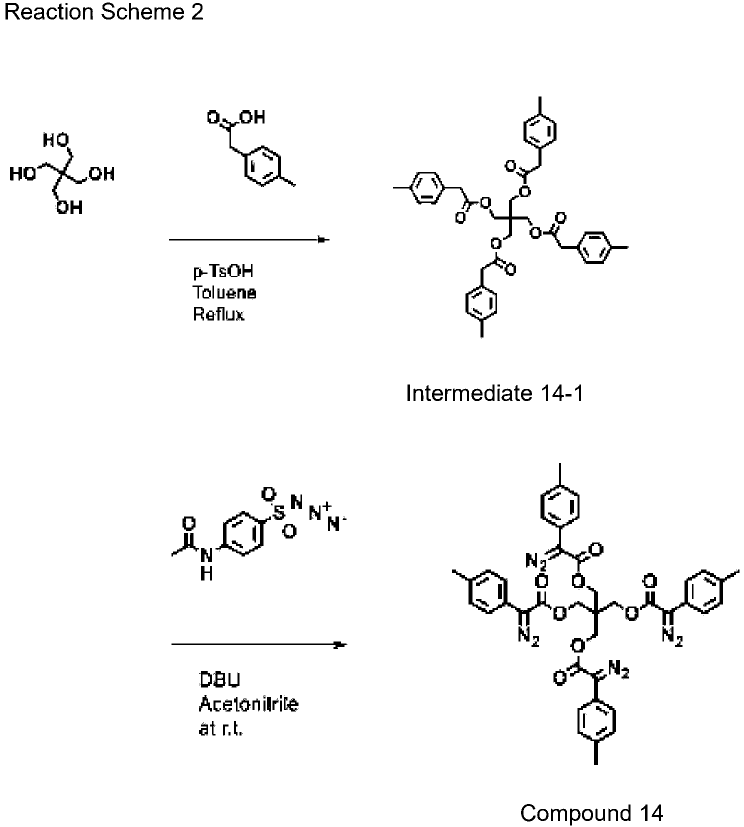

In a 300 mL three-necked flask, pentaerythritol (14.69 mmol, 2 g), p-tolylacetic acid (61.70 millimole (mmol), 9.27 g), p-toluenesulfonic acid (12.34 mmol, 2.35 g), and toluene (73 mL) were added and stirred under reflux under a nitrogen atmosphere. After completion of the reaction, the obtained solution was neutralized with a 1% aqueous sodium hydroxide solution. Thereafter, the organic layer was washed with an 8% aqueous sodium carbonate solution and purified water. The organic layer was dried over magnesium sulfate and filtered. The resulting solution was concentrated, diluted with dichloromethane (10 mL), and methanol (75 mL) was added to precipitate a solid. The resulting solid was vacuum-dried (50°C, 16 hours) to obtain Intermediate 14-1 (yield 6.2 g, yield 63%).

In a 200 mL four-necked flask, Intermediate 14-1 (1.50 mmol, 1.0 g), diazabicycloundecene (7.82 mmol, 1.88 g), and acetonitrile (75.2 mL) were added and stirred. Then, p-acetamidebenzenesulfonic acid azide (7.82 mmol, 1.88 g) was slowly added, and the mixture was stirred at room temperature for 24 hours. After stopping the reaction by adding pure water to the reaction solution, the mixture was separated into dichloromethane and pure water. The organic layer was dried over magnesium sulfate and filtered. The resulting solution was concentrated and recrystallized using methanol. The obtained solid was vacuum-dried (50°C, 16 hours) to obtain compound 14 (amount 0.4 g, yield 35%).

### Synthesis Example 3: Synthesis of Compound 20

Compound 20 was synthesized as described in Reaction Scheme 3 below.

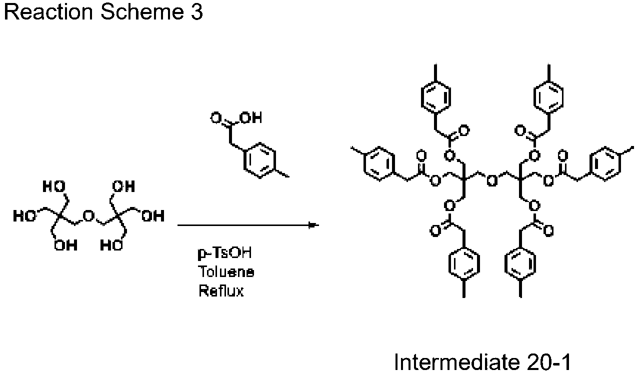

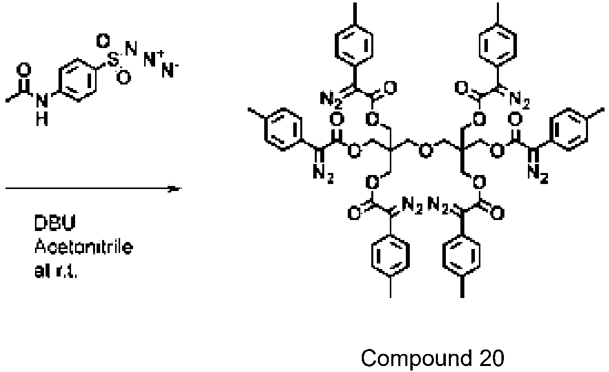

In a 200 mL three-necked flask, dipentaerythritol (11.80 mmol, 3.0 g), p-tolylacetic acid (74.33 mmol, 11.16 g), p-toluenesulfonic acid (7.43 mmol, 1.41 g), and toluene (59 mL) were added and refluxed under a nitrogen atmosphere. After completion of the reaction, the obtained solution was neutralized with a 1% aqueous sodium hydroxide solution. Thereafter, the organic layer was washed with an 8% aqueous sodium carbonate solution and purified water. The organic layer was dried over magnesium sulfate and filtered. The obtained solution was concentrated, diluted with dichloromethane (10 mL), and methanol (75 mL) was added to precipitate a solid. The obtained solid was vacuum dried (50°C, 16 hours) to obtain Intermediate 20-1 (quantity 7.0 g, yield 57%).

In a 200 mL four-necked flask, Intermediate 20-1 (0.95 mmol, 1.0 g), diazabicycloundecene (12.60 mmol, 1.92 g), and acetonitrile (48 mL) were added and stirred. Then, p-acetamidebenzenesulfonic acid azide (11.46 mmol, 2.75 g) was slowly added, and the mixture was stirred at room temperature for 12 hours. After stopping the reaction by adding pure water to the reaction solution, the mixture was partitioned between ethyl acetate and pure water. The organic layer was dried over magnesium sulfate and filtered. The resulting solution was concentrated and recrystallized using methanol. The obtained solid was vacuum dried (50°C, 16 hours) to obtain Compound 20 (amount 0.5 g, yield 44%).

### Synthesis Example 4: Synthesis of Compound 17

Compound 17 was synthesized as described in Reaction Scheme 4 below.

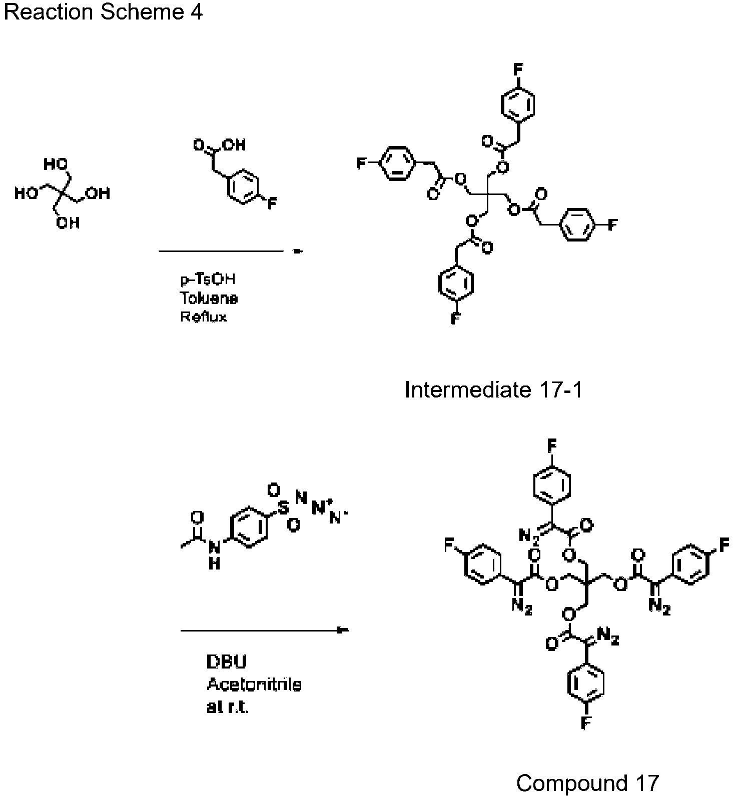

In a 300 mL three-necked flask, pentaerythritol (22.03 mmol, 3.0 g), 4-fluorophenylacetic acid (92.54 mmol, 14.27 g), p-toluenesulfonic acid (18.51 mmol, 3.52 g), and toluene (110 mL) were placed and refluxed under a nitrogen atmosphere. After completion of the reaction, the obtained solution was neutralized with a 1% aqueous sodium hydroxide solution. Thereafter, the organic layer was washed with an 8% aqueous sodium carbonate solution and purified water. The organic layer was dried over magnesium sulfate and filtered. The obtained solution was concentrated, diluted with dichloromethane (10 mL), and methanol (75 mL) was added to precipitate a solid. The obtained solid was vacuum dried (50°C, 16 hours) to obtain Intermediate 17-1 (amount 10.9 g, yield 74%).

In a 200 mL four-necked flask, Intermediate 17-1 (1.47 mmol, 1.0 g), diazabicycloundecene (14.69 mmol, 2.24 g), and acetonitrile (73.5 mL) were added and stirred. Then, p-acetamide benzenesulfonic acid azide (14.69 mmol, 3.53 g) was slowly added, and the mixture was stirred at room temperature for 12 hours. After stopping the reaction by adding pure water to the reaction solution, the mixture was separated into dichloromethane and pure water. The organic layer was dried over magnesium sulfate and filtered. The resulting solution was concentrated and recrystallized using methanol. The obtained solid was vacuum-dried (50°C, 16 hours) to obtain Compound 17 (amount 0.88 g, yield 77%).

### Synthesis Example 5: Synthesis of Compound 23

Compound 23 was synthesized as described in Reaction Scheme 5 below.

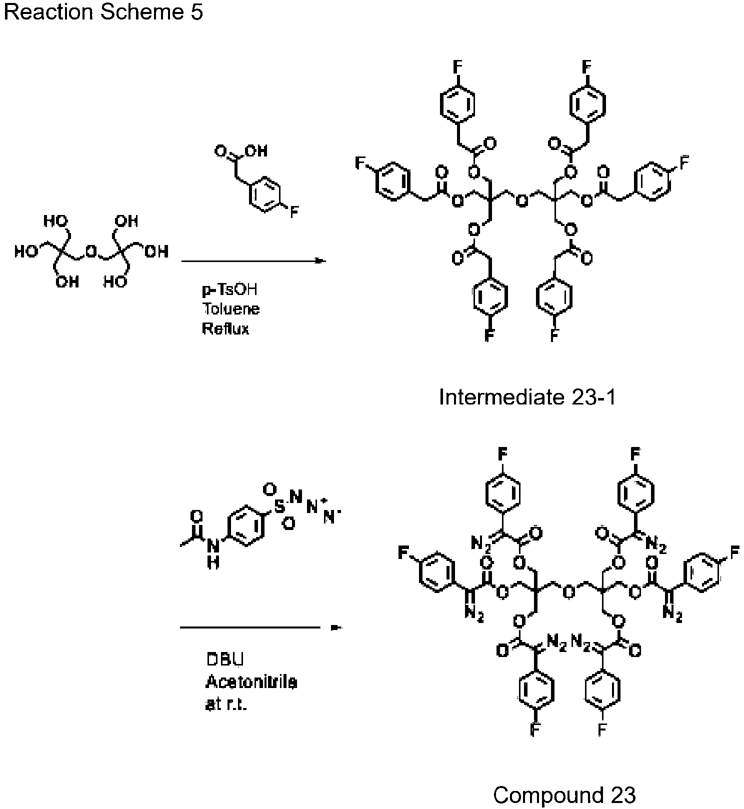

In a 200 mL three-necked flask, dipentaerythritol (11.80 mmol, 3.0 g), 4-fluorophenylacetic acid (74.33 mmol, 11.5 g), p-toluenesulfonic acid (7.43 mmol, 1.41 g), and toluene (59 mL) were added and refluxed under a nitrogen atmosphere. After completion of the reaction, the obtained solution was neutralized with a 1% aqueous sodium hydroxide solution. Thereafter, the organic layer was washed with an 8% aqueous sodium carbonate solution and purified water. The organic layer was dried over magnesium sulfate and filtered. The obtained solution was concentrated, diluted with dichloromethane (10 mL), and methanol (75 mL) was added to precipitate a solid. The obtained solid was vacuum dried (50°C, 16 hours) to obtain Intermediate 23-1 (amount 2.2 g, yield 17%).

In a 200 mL four-necked flask, intermediate 23-1 (0.93 mmol, 1.0 g), diazabicycloundecene (15.41 mmol, 2.34 g), and acetonitrile (48 mL) were added and stirred. Then, p-acetamidebenzenesulfonic acid azide (14.01 mmol, 3.37 g) was slowly added, and the mixture was stirred at room temperature for 12 hours. After stopping the reaction by adding pure water to the reaction solution, the mixture was separated into ethyl acetate and pure water. The organic layer was dried over magnesium sulfate and filtered. The resulting solution was concentrated and recrystallized using methanol. The obtained solid was vacuum-dried (50°C, 16 hours) to obtain Compound 23 (amount 0.87 g, yield 75%).

### Evaluation of Crosslinking Reaction

The reaction initiation temperatures and completion times for Compounds 7, 14, 17, 20, and 23 synthesized in Synthesis Examples 1 through 5, as well as the following comparative compound, were evaluated, and the results are shown in Table 1.

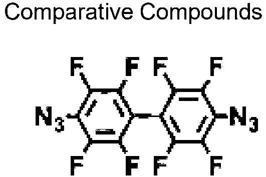

### (Reaction Initiation Temperature)

Compounds 7, 14, 17, 20, 23, and the above-mentioned comparative compound were each measured using a differential scanning calorimeter (DSC) (Seiko Instruments, trade name: DSC6000) with a profile heated from room temperature to 320°C with a heating rate of 10°C/min. The temperature at which the exothermic peak occurred was defined as the reaction initiation temperature.

### (Reaction Completion Time)

Compounds 7, 14, 17, 20, 23, and the above-mentioned comparative compounds were each measured using a differential scanning calorimeter (DSC) (Seiko Instruments, trade name: DSC6000) with a profile heated from room temperature to 140°C at a heating rate of 10°C/min, and held at 140°C for 60 minutes. The reaction completion time was defined as the time from the time the temperature reached 140°C to the time the heat capacity reached zero.

**Table 1**

| | Comparative Comp. | Comp. 7 | Comp. 14 | Comp. 20 | Comp. 17 | Comp. 23 |
|---|---|---|---|---|---|---|
| Reaction Initiation Temp.(°C) | 125 | 87 | 98 | 88 | 115 | 105 |
| Reaction Completion Time (min.) | > 60 | 6 | 9 | 4 | 12 | 5 |

As shown in Table 1 above, it can be seen that the reactive organic compound according to an embodiment has a lower reaction initiation temperature and a shorter reaction completion time compared to the comparative compound.

### Example 1

Quantum dot dispersion was prepared by referring to "Synthesis of InP cores" and "Synthesis of InP/ZnSe/ZnS QDs" of "Methods" of Nature volume 575, pp. 634 to 638 (2019) (core: InP, shell: ZnSe/ZnS, content of quantum dots in the dispersion: 2 wt%, maximum emission wavelength of the quantum dots: 627 nm, organic ligand: oleic acid (SP value, when coordinated to the surface of the quantum dots: 8.1 (cal/cm³)^{1/2}, average particle diameter of the quantum dots: 10 nanometers (nm). The amount of the oleic acid coordinated to the quantum dots was 10 parts by weight, with respect to 100 parts by weight of the quantum dots. Ethanol was added to the obtained quantum dot dispersion to produce a precipitate, and after removing the supernatant, the precipitate was collected through centrifugation.

To the precipitate obtained above, 3 mL of cyclohexylbenzene as a solvent was added, stirred with a shaker (temperature at the time of mixing: 25°C, mixing time: 10 minutes), and the precipitate was dispersed in the solvent. The amount of the quantum dots (InP/ZnSe/ZnS) in the dispersion was 3 wt%. Compound 7 synthesized in Synthesis Example 1 was added to the dispersion so as to be 5 parts by weight with respect to the amount of quantum dots in the dispersion, whereby preparing ink composition 1.

### Example 2

Ink Composition 2 was prepared in the same manner as in Example 1 except that Compound 14 was synthesized in Synthesis Example 2 was used instead of Compound 7, and Compound 14 was added so as to be 1 part by weight with respect to the amount of the quantum dots in the dispersion.

### Example 3

Ink Composition 3 was prepared in the same manner as in Example 2 except that Compound 20 synthesized in Synthesis Example 3 was used instead of Compound 14.

### Comparative Example 1

To the precipitate obtained in Example 1, 3 mL of cyclohexylbenzene as a solvent was added, stirred with a shaker (temperature at the time of mixing: 25°C, mixing time: 10 minutes), and the precipitate was dispersed in the solvent to prepare Comparative Ink Composition 1. The amount of the quantum dots (InP/ZnSe/ZnS) in Comparative Ink Composition 1 was 3 wt%.

### Evaluation of Lamination Stability (Process Stability)

Ink Compositions 1, 2, 3, and Comparative Ink Composition 1 were each applied by spin coating to be a dry film thickness of 30 nm. Each was then heat-treated at 140°C for 30 minutes to form a thin film. The UV absorption spectrum of each thin film was measured. Then, a solvent (cyclohexylbenzene) was added dropwise to each thin film and allowed to permeate for 10 minutes. After removing the solvent, the UV absorption spectrum of each thin film was measured. The lamination stability was evaluated by dividing the intensity of the spectrum after solvent addition by the intensity of the spectrum before solvent addition (as a percentage). The results are shown in Table 2. In Table 2, the amount of reactive organic compound is the amount added to each composition and with respective to the quantum dot content (3 wt%).

**Table 2**

| Ink Composition | Reactive Organic Compound | Amount of Reactive Organic Compound | Lamination Stability |
|---|---|---|---|
| Example 1 | Compound 7 | 5 parts by weight | 99% |
| Example 2 | Compound 14 | 1 part by weight | 95% |
| Example 3 | Compound 20 | 1 part by weight | 97% |
| Comparative Example 1 | None | 0 part by weight | 90% |

As shown in Table 2, the thin films produced using Ink Compositions 1 to 3 exhibit higher lamination stability compared to the thin film produced using Comparative Ink Composition 1. Accordingly, it is believed that the quantum dot light-emitting layers produced using Ink Compositions 1 to 3 may suppress dissolution during lamination, and thus process stability can be secured by using Ink Compositions 1 to 3.

### Manufacturing Example 1

As the first electrode (anode), an indium tin oxide (ITO)-attached glass substrate, in which the indium tin oxide is patterned with a film thickness of 150 nm, was used. This ITO-attached glass substrate was sequentially washed with a neutral detergent, deionized water, water, and isopropyl alcohol, and then UV-ozone treatment was performed. Next, poly(3,4-ethylenedioxythiophene)/poly(4-styrenesulfonate) (PEDOT/PSS) (manufactured by Sigma-Aldrich) was spin-coated onto this ITO-attached glass substrate to a dry film thickness of 30 nm, and then dried. As a result, a hole injection layer with a thickness (dry film thickness) of 30 nm was formed on the ITO-attached glass substrate.

A 1.0 wt% toluene solution of Polymer Compound P-1 (hole transport material) shown below was spin-coated onto the hole injection layer to a dry film thickness of 30 nm, followed by heat treatment at 230°C for 60 minutes to form a hole transport layer. As a result, a hole transport layer with a thickness (dry film thickness) of 30 nm was formed on the hole injection layer.

Polymer Compound P-1 was synthesized according to the manufacturing method described in Japanese Patent Application Laid-Open No. 2024-82022. Polymer Compound P-1 is presumed to have the following structure:

### Polymer Compound P-1

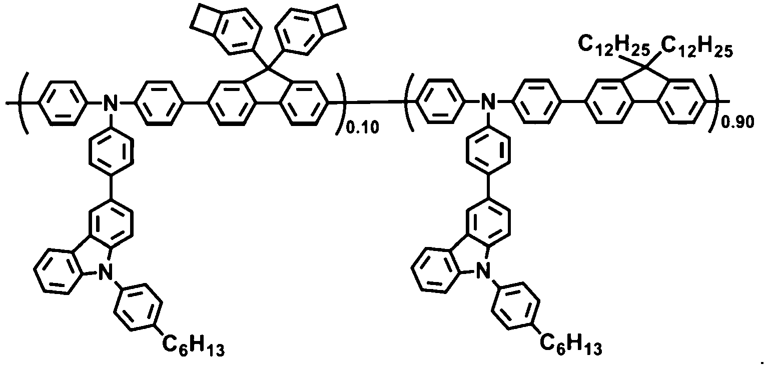

Terminal structure of Polymer Compound P-1 is presumed to be one of the structures below:

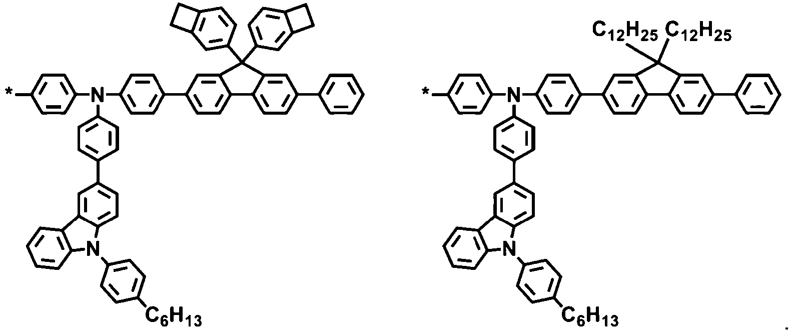

Ink Composition 1 was applied onto the hole transport layer by spin coating to a dry film thickness of 30 nm, and then dried. As a result, a quantum dot light-emitting layer having a thickness (dry film thickness) of 30 nm was formed on the hole transport layer. The light emitted by irradiating the quantum dot light-emitting layer with ultraviolet light had a center wavelength of 462 nm and a full width at half maximum (FWHM) of 30 nm.

The quantum dot light-emitting layer was completely dried. ZnMgO was dispersed in ethanol at a concentration of 1.5 wt% to prepare a dispersion for forming an electron transport layer. This dispersion was applied onto the quantum dot light-emitting layer by spin coating to have a dry film thickness of 60 nm, and then dried. As a result, an electron transport layer with a dry film thickness of 60 nm was formed on the quantum dot light-emitting layer.

Using a vacuum deposition apparatus, (8-quinolinonato)lithium (lithium quinolate) (Liq) was deposited on the electron transport layer. As a result, a 0.5 nm-thick electron injection layer was formed on the electron transport layer.

Aluminum (Al) was deposited on the electron injection layer using a vacuum deposition apparatus. As a result, a 100 nm-thick second electrode (cathode) was formed on the electron injection layer. Thus, Quantum Dot Electroluminescent Device 100 was obtained.

### Comparative Manufacturing Example 1

Comparative Quantum Dot Electroluminescent Device 1 was fabricated in the same manner as Manufacturing Example 1, except that Comparative Ink Composition 1 was used instead of Ink Composition 1.

### Evaluation of Device Performance

### (Luminescence Characteristics)

When voltage is applied to each quantum dot electroluminescence device, current begins to flow at a constant voltage, and the quantum dot electroluminescence device emits light. Using a DC constant voltage power supply (source meter manufactured by KEYENCE), when voltage is applied to each quantum dot electroluminescence device, current begins to flow at a constant voltage, and the quantum dot electroluminescence device emits light. The luminescence of each element was measured using a luminance measuring device (Topcon, SR-3), while gradually increasing the current. When the luminance reached 650 nit (cd/m²), the current was kept constant and left to stand. In Table 3, the difference between the initial voltage (V) at 650 nits and the voltage (V) after 100 hours was defined as "ΔV@100hr," and the change of voltage per hour from the initial voltage (V) was defined as "ΔV/hr."

### (Luminous lifespan)

Using a DC constant voltage power supply (source meter manufactured by Keyence Co., Ltd.), a predetermined voltage was applied to each quantum dot electroluminescent device, and each quantum dot electroluminescent device was made to emit light. While measuring the luminescence of the quantum dot electroluminescent device with a luminance measuring device (SR-3 manufactured by Topcon Co., Ltd.), the current was gradually increased, and when the luminance reached 650 nit (cd/m²), the current was kept constant and left to stand. In Table 3, the time until the luminance value measured by the luminance measuring device gradually decreases and reaches 90% of the initial luminance (650 nit) was defined as "Max. T90 (hr)."

**Table 3**

| | Ink Composition | ΔV@100hr | ΔV/hr | Max.T90(hr) |
|---|---|---|---|---|
| Manufacturing Example 1 | Ink Composition 1 | 1.0 | 0.010 | 53 |
| Comparative Manufacturing Example 1 | Comparative Ink Composition 1 | 1.8 | 0.017 | 40 |

From the results in Table 3, it can be seen that the quantum dot electroluminescent device according to Manufacturing Example 1 has suppressed performance degradation by having a light-emitting layer formed using the ink composition according to an embodiment. Specifically, it can be seen that the quantum dot electroluminescent device of Manufacturing Example 1 has a device lifespan that is improved by about 1.3 times and an increase in driving voltage is suppressed compared to the quantum dot electroluminescent device of Comparative Manufacturing Example 1.

While this disclosure has been described in connection with what is presently considered to be practical example embodiments, it is to be understood that the invention is not limited to the disclosed embodiments. On the contrary, it is intended to cover various modifications and equivalent arrangements included within the scope of the appended claims.

## Claims

1. An ink composition comprising:
a plurality of quantum dots,
a reactive organic compound, and
a solvent,
wherein the plurality of quantum dots do not include cadmium or lead, and
the reactive organic compound is represented by Chemical Formula 1: 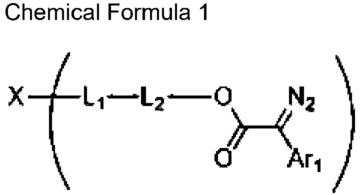
in Chemical Formula 1,
Ar₁ is a substituted or unsubstituted aromatic hydrocarbon group having 6 to 60 carbon atoms,
L₁ is a single bond, or an oxygen atom,
L₂ is a single bond, a substituted or unsubstituted saturated hydrocarbon group having 1 to 60 carbon atoms, or a substituted or unsubstituted aromatic hydrocarbon group having 6 to 60 carbon atoms, and
X is a group selected from the groups represented by the following formulae (1-1) to (1-37): 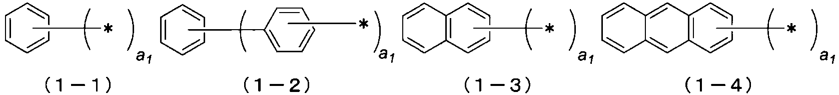 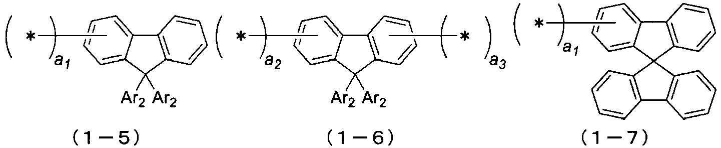 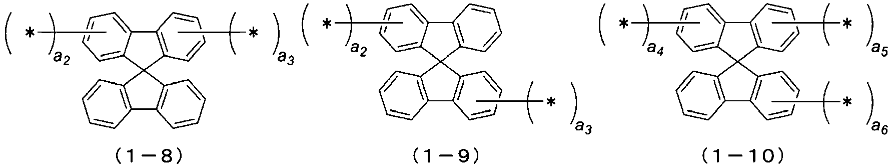 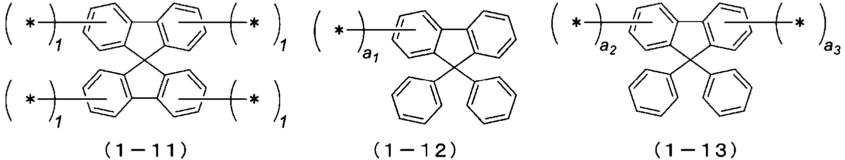 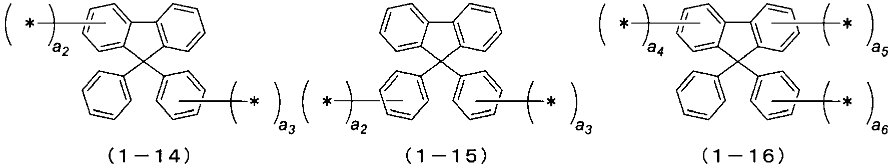 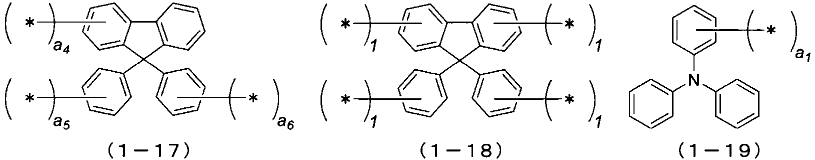 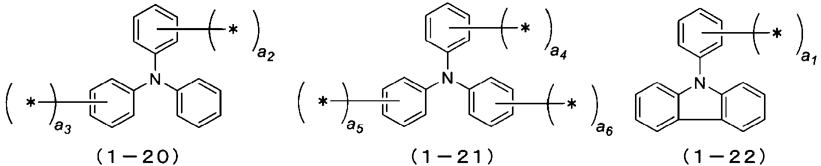 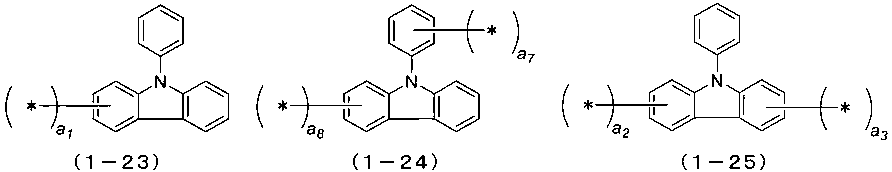 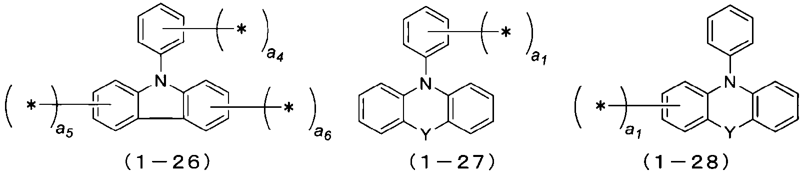 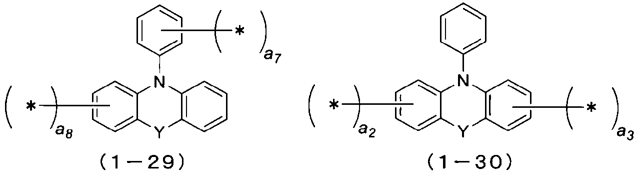 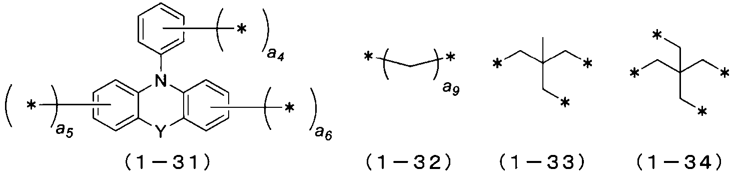 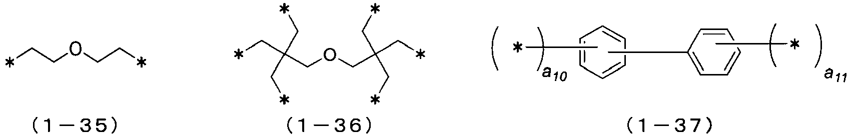
in the formulae (1-1) to (1-37), * represents a binding site,
in the formulae (1-1) to (1-5), (1-7), (1-12), (1-19), (1-22), (1-23), (1-27), and (1-28), a1 independently represents an integer of greater than or equal to 2 and less than or equal to 4,
in the formulae (1-6), (1-8), (1-9), (1-13) to (1-15), (1-20), (1-25), and (1-30), a2 independently represents an integer of greater than or equal to 1 and less than or equal to 3, a3 independently represents 1 or 2, and the sum of a2 and a3 is independently 2, 3, or 4,
in the formulae (1-10), (1-16), (1-17), (1-21), (1-26), and (1-31), a4 independently represents 1 or 2, a5 independently represents 1, a6 independently represents 1 or 2, and the sum of a4, a5, and a6 independently represents 3 or 4,
in the formulae (1-24) and (1-29), a7 independently represents an integer of greater than or equal to 1 and less than or equal to 3, a8 independently represents an integer of greater than or equal to 1 and less than or equal to 3, and the sum of a7 and a8 independently represents 2, 3, or 4,
in the formula (1-32), a9 is an integer of greater than or equal to 2 and less than or equal to 18,
in the formula (1-37), a10 represents 1 or 2, and a11 represents 1 or 2,
in the formulae (1-5) and (1-6), Ar₂ is each independently a substituted or unsubstituted aromatic hydrocarbon group having 6 to 60 carbon atoms, and
in the formulae (1-27) to (1-31), Y is each independently -O-, -S-, -C(CH₃)₂-, or a diphenylmethylene group.

2. The ink composition of claim 1, wherein the solvent comprises a compound represented by any one of formulae (2) to (5): 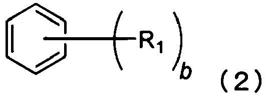 wherein in formula (2),
R₁ is a linear or branched saturated hydrocarbon group having 1 to 18 carbon atoms, or a cyclic saturated hydrocarbon group having 3 to 12 carbon atoms, and
b represents an integer of greater than or equal to 1 and less than or equal to 3; 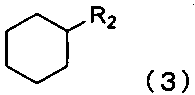
wherein in formula (3),
R₂ is a linear or branched saturated hydrocarbon group having 1 to 18 carbon atoms, or a cyclic saturated hydrocarbon group having 3 to 12 carbon atoms; 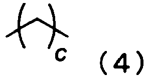
wherein in formula (4),
c represents an integer of greater than or equal to 6 and less than or equal to 18; and 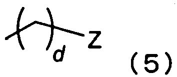
wherein in formula (5),
Z represents -OH, -COOH, -NH₂-, or -SH, and
d represents an integer of greater than or equal to 7 and less than or equal to 17.

3. The ink composition of claims 1 or 2, wherein an average particle diameter of the plurality of quantum dots is from 1 nanometer to 15 nanometers; and/or
wherein an amount of the plurality of quantum dots is from 0.1 weight percent to 10.0 weight percent based on a total weight of the ink composition.

4. The ink composition of any of claims 1-3, wherein an amount of the reactive organic compound is 0.1 parts by weight to 10.0 parts by weight with respect to 100 parts by weight of the plurality of quantum dots in the ink composition.

5. The ink composition of any of claims 1-4, wherein the X in Chemical Formula 1 is a group selected from the groups represented by formulae (1-38) to (1-105): 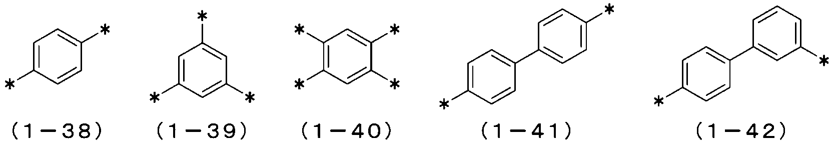 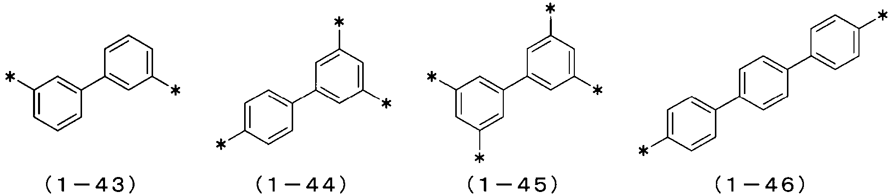 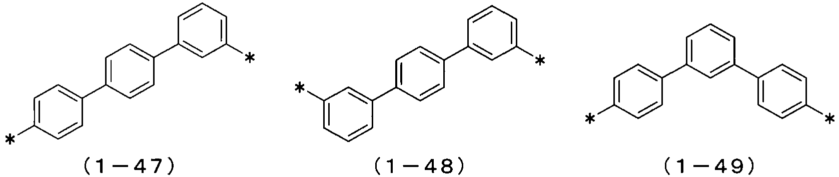 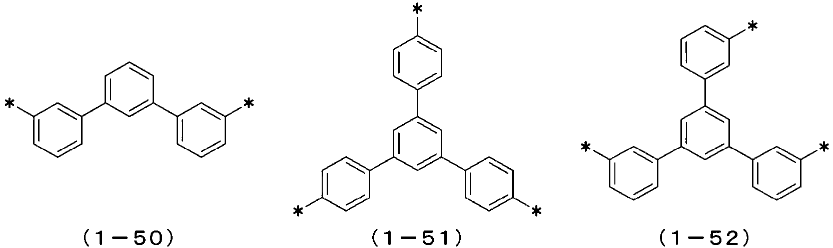 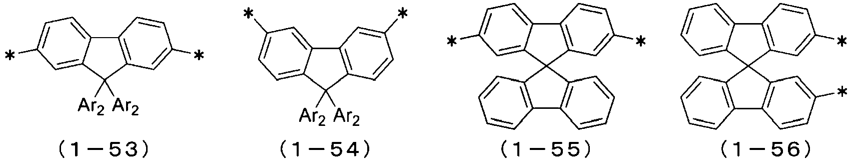 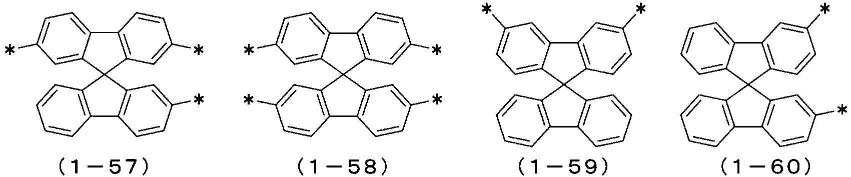 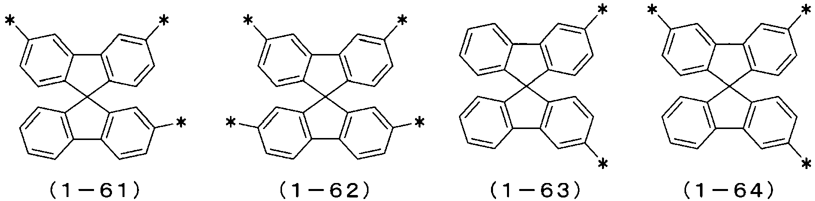 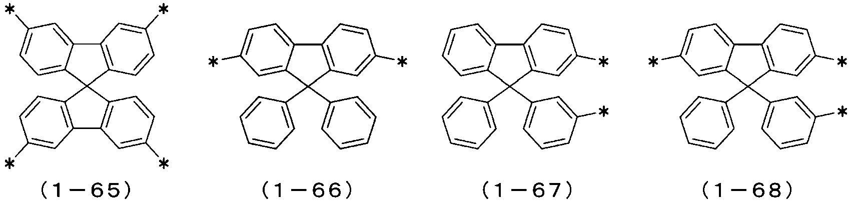 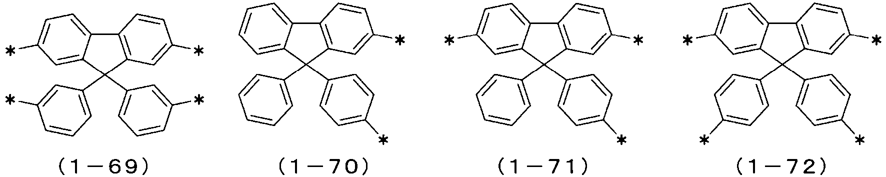 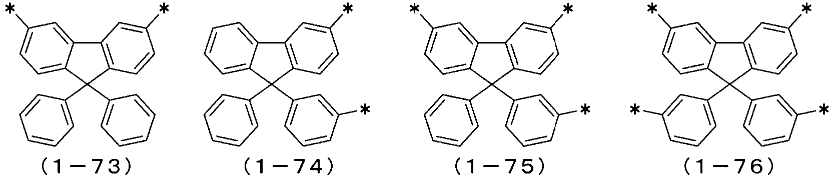 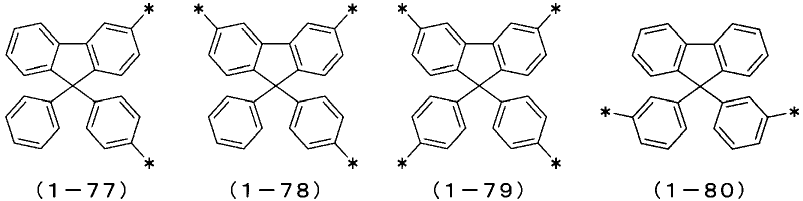 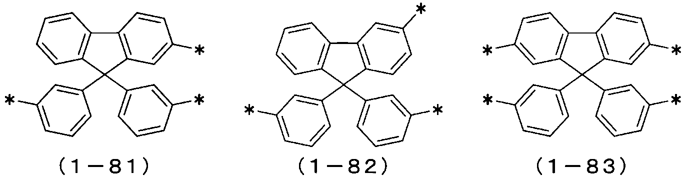 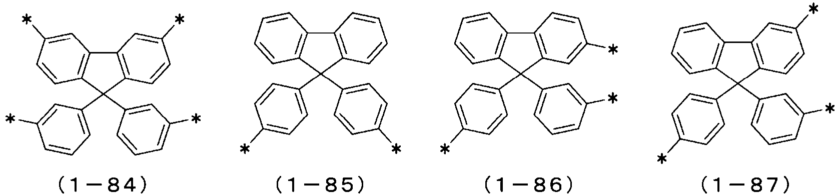 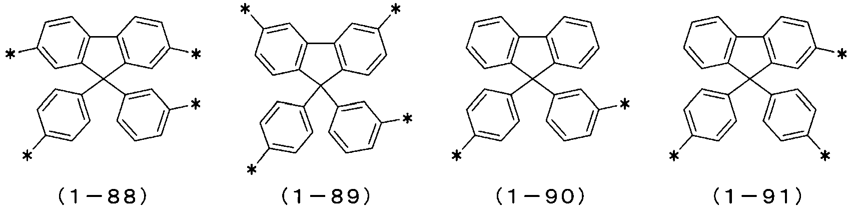 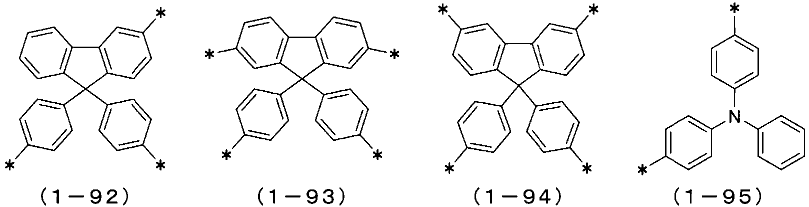 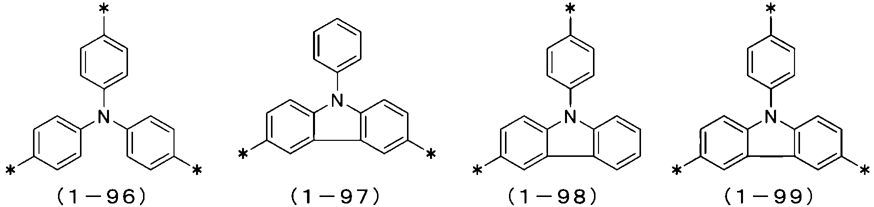 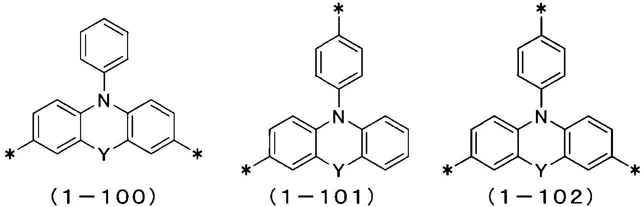 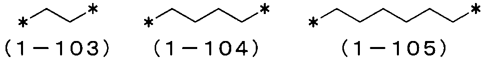
wherein in chemical formulae (1-53) and (1-54), Ar₂ is independently a substituted or unsubstituted aromatic hydrocarbon group having 6 to 60 carbon atoms, and
wherein in formulae (1-100) to (1-102), Y is independently -O-, -S-, -C(CH₃)₂-, or a diphenylmethylene group.

6. The ink composition of any of claims 1-5, wherein the X in Chemical Formula 1 is selected from formula (1-34) or formula (1-36).

7. The ink composition of any of claims 1-6, wherein the reactive organic compound is represented by at least one of Compound 1 to Compound 24:

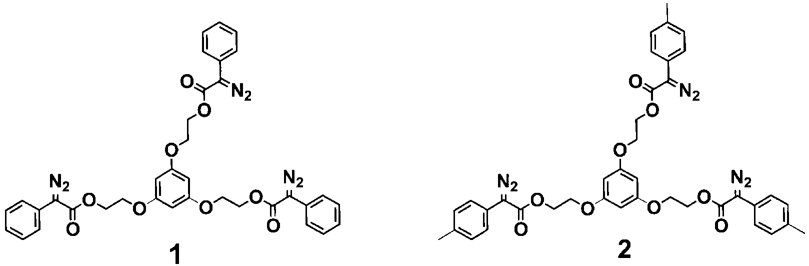

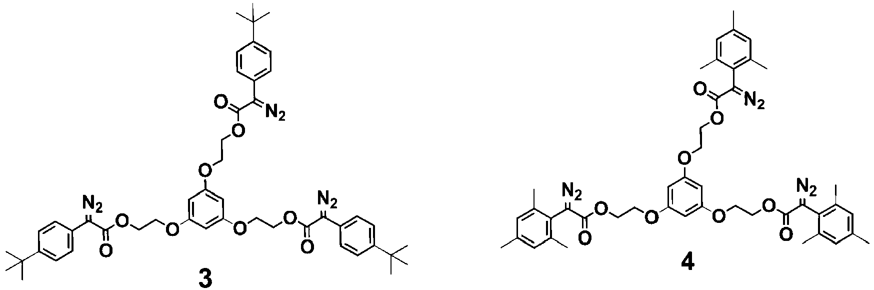

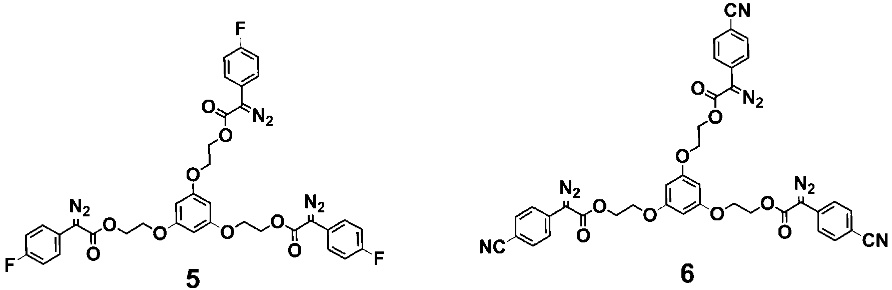

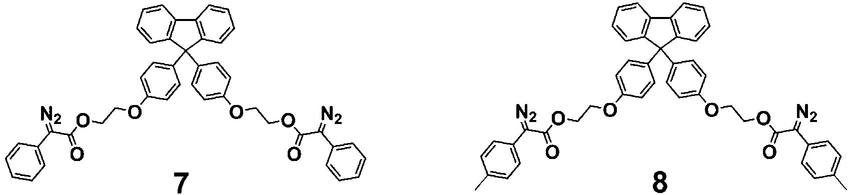

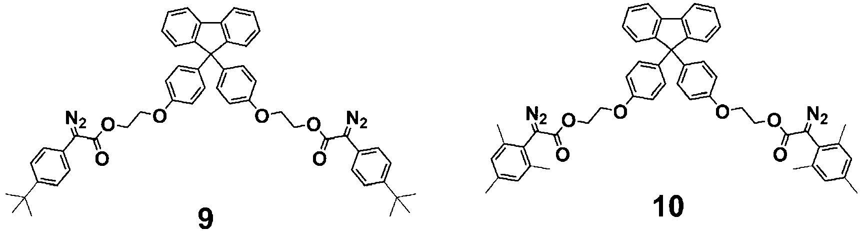

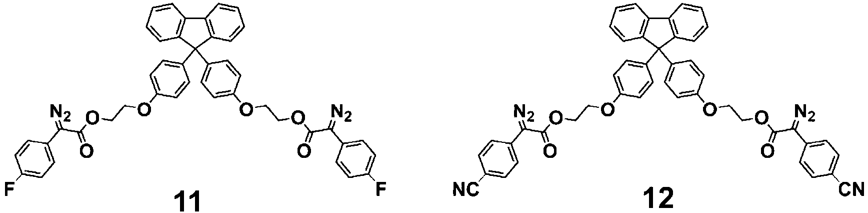

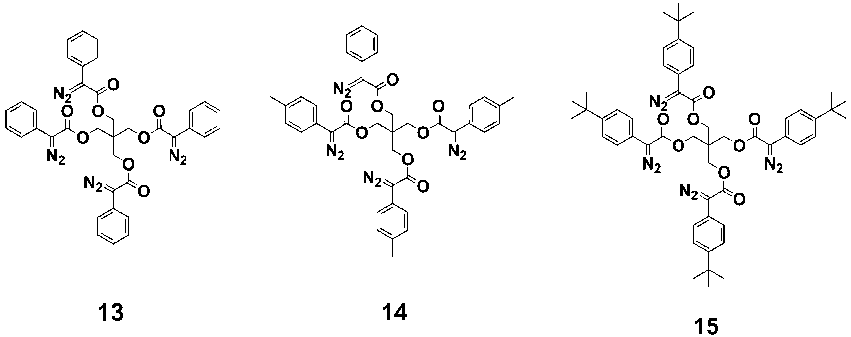

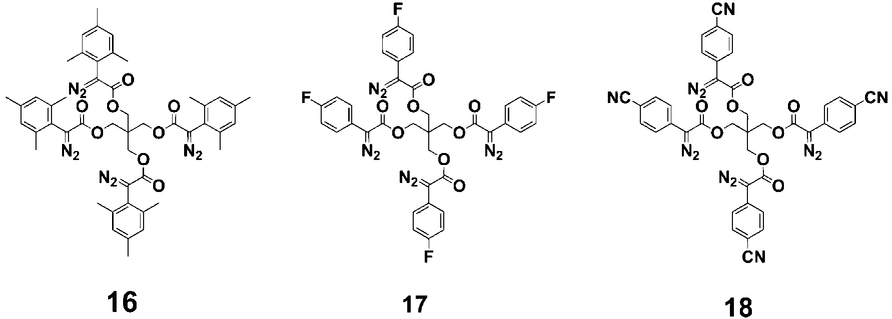

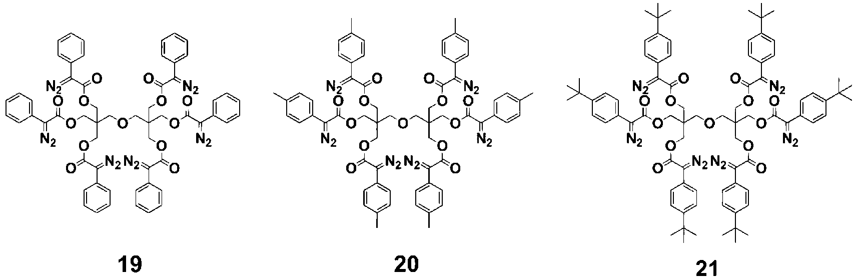

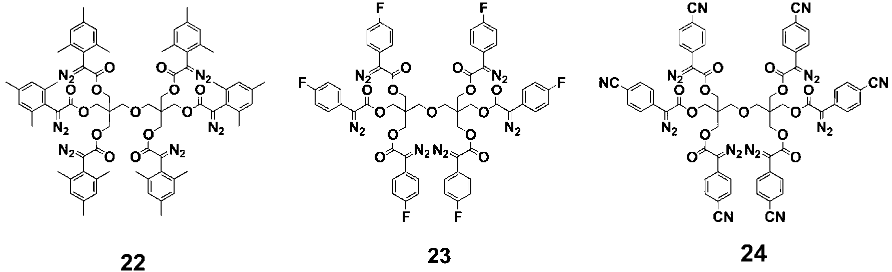

8. The ink composition of any of claims 1-7, wherein the reactive organic compound is represented by Compound 7, Compound 14, Compound 20, Compound 23, or a combination thereof.

9. The ink composition of any of claims 2-8, wherein R₁ of formula (2) is a linear or branched saturated hydrocarbon group having 1 to 10 carbon atoms, or a cyclic saturated hydrocarbon group having 3 to 6 carbon atoms.

10. The ink composition of any of claims 2-9, wherein R₂ of formula (3) is a linear or branched saturated hydrocarbon group having 6 to 10 carbon atoms, or a cyclic saturated hydrocarbon group having 3 to 6 carbon atoms.

11. The ink composition of any of claims 1-10, wherein a surface of the plurality of quantum dots is coordinated by an organic ligand selected from a halogenated alkyl compound, a mercapto group-containing compound, an aliphatic carboxylic acid compound, or a combination thereof;
preferably wherein an amount of the organic ligand is greater than or equal to 1 part by weight and less than or equal to 30 parts by weight, with respect to 100 parts by weight of the plurality of quantum dots.

12. A quantum dot electroluminescent device comprising a light emitting layer formed from the ink composition of any of claims 1-11;
preferably wherein the light emitting layer is formed using an inkjet device.

13. An image display device comprising the quantum dot electroluminescent device of claim 12.

14. A method of fabricating a quantum dot electroluminescent device, the quantum dot electroluminescent device comprising a light emitting layer formed from the ink composition of any of claims 1-11,
wherein the light emitting layer is formed using an inkjet device.

15. An electronic device comprising the quantum dot electroluminescent device of claim 12.
